# FASCICULE DE BREVET EUROPEEN

(11) **EP 2 038 929 B1**
(45) Date de publication et mention de la délivrance du brevet: **27.03.2013**
(21) Numéro de dépôt: 07803997.1
(22) Date de dépôt: 09.07.2007
(51) Int. Cl.: H01L 25/065, H01L 31/05, H01L 25/075, H01L 21/683

(54) **PROCÉDÉ POUR LA RÉALISATION D'UNE MATRICE DE COMPOSANTS ÉLECTRONIQUES INDIVIDUELS ET MATRICE RÉALISÉE PAR CE PROCÉDÉ**
VERFAHREN ZUR HERSTELLUNG EINER MATRIX AUS EINZELNEN ELEKTRONISCHEN KOMPONENTEN UND AUF DIESE WEISE HERGESTELLTE MATRIX
METHOD FOR PRODUCING A MATRIX OF INDIVIDUAL ELECTRONIC COMPONENTS AND MATRIX PRODUCED THEREBY

(30) Priorité: 12.07.2006 FR 0652926
(43) Date de publication de la demande: 25.03.2009
(73) Titulaire: Commissariat à l'Énergie Atomique et aux Énergies Alternatives, 75015 Paris (FR)
(72) Inventeur: MARION, François, 38950 Saint Martin Le Vinoux (FR); GRAVRAND, Olivier, 38120 Fontanil Cornillon (FR)
(74) Mandataire: Vuillermoz, Bruno
(86) Numéro de dépôt international: PCT/FR2007/051618
(87) Numéro de publication internationale: WO 2008/007008

(56) Documents cités:
- EP-A- 1 583 147
- US-A1- 2006 060 954
- US-B2- 6 743 982

## Description

### DOMAINE DE L'INVENTION

La présente invention se rapporte au domaine de l'intégration de composants électroniques individualisés et à la densification fonctionnelle des surfaces de circuits intégrés comportant de tels composants électroniques.

L'invention concerne plus particulièrement un procédé de réalisation d'une matrice de composants électroniques individuels, du type comportant une étape de fabrication d'une couche active sur une base de substrat, notamment par épitaxie, et une étape d'individualisation desdits composants par formation de tranchées, notamment par gravure, dans la couche active, au moins jusqu'à dégager la base de substrat.

L'invention concerne également une matrice d'au moins deux composants électroniques individualisés dans une couche active au moyen de tranchées traversantes formées dans celle-ci.

### ETAT ANTERIEUR DE LA TECHNIQUE

Dans un dispositif électronique matriciel, comme par exemple un détecteur matriciel, les éléments unitaires formant la matrice, ou « pixels » par analogie au domaine de l'imagerie, sont individualisés par des tranchées afin de définir des comportements locaux indépendants. Par exemple, dans le cas d'un détecteur matriciel, un composant individuel permet de mesurer un rayonnement incident sur celui-ci indépendamment des autres composants, ce qui permet au final de former une image de points distincts.

L'espace inter - composant ainsi défini est généralement perçu comme un inconvénient, non seulement parce qu'il limite le degré d'intégration des composants par unité de surface, mais également parce que ce volume est considéré comme difficilement utilisable à l'aide des techniques usuelles sans dégrader le comportement des composants adjacents ou induire un taux de défaillance élevé.

A titre d'exemple, des connexions électriques entre des composants adjacents ont été réalisées à l'aide de fils électriques soudés sur les faces supérieures des composants, comme par exemple dans le document US-B-6743982. Or un fil soudé est fragile de part la soudure mise en oeuvre, et utilise en outre une portion de la surface utile des composants.

Le but de la présence invention est de résoudre le problème susmentionné en proposant une matrice de composants individuels et un procédé de réalisation de celle-ci, dans lesquels l'espace inter - composants est utilisé de manière optimale, par exemple pour assurer des connexions électriques fiables entre des pixels adjacents, pour absorber des déplacements relatifs entre des pixels adjacents ou pour augmenter la densité des pixels en réduisant les surfaces occupées par les interconnexions.

On notera que l'invention s'applique au domaine de la fabrication de matrices de composants électroniques, dont certaines dimensions, notamment celles de l'espace séparant les composants, sont inférieures à la dizaine de micromètres. Comme cela est connu, la fabrication de tels composants est sujette à des problèmes spécifiques qui nécessitent la mise en oeuvre de techniques particulières à ces ordres de grandeur, comme par exemple la photolithographie.

### EXPOSE DE L'INVENTION

A cet effet, l'invention a pour objet un procédé de réalisation d'une matrice de composants électroniques individuels, du type comportant une étape de réalisation d'une couche active sur une base de substrat, notamment par épitaxie, et une étape d'individualisation desdits composants par formation de tranchées, notamment par gravure, dans la couche active, au moins jusqu'à dégager la base de substrat.

Selon l'invention, le procédé comporte des étapes consistant à :
■ déposer une couche de matériau fonctionnel sur la couche active ;
■ déposer une résine photosensible à un rayonnement prédéterminé sur la couche de matériau fonctionnel de manière à remplir lesdites tranchées et à former une pellicule mince sur la face supérieure des composants électroniques ;
■ exposer au moins partiellement la résine audit rayonnement tout en sous-exposant la portion de résine remplissant les tranchées ;
■ développer la résine de manière à éliminer la portion de celle-ci correctement exposée ;
■ éliminer la portion de couche de matériau fonctionnel affleurante à la suite de l'étape de développement ; et
■ éliminer la portion de résine restante.

En d'autres termes, la couche de matériau fonctionnel est protégée par la résine remplissant les tranchées lors des étapes consécutives à l'exposition. En effet, le fait de sous-exposer la résine des tranchées empêche le développement de celle-ci. De fait, une fois les opérations de fonctionnalisation des composants électroniques achevées (gravure, attaque ionique, ...), la couche de matériau fonctionnel dans les tranchées est intacte. Ainsi, après élimination de la résine des tranchées, par exemple par un bain chimique, il est obtenu un film de matériau fonctionnel reliant des composants électroniques adjacents.

On remarque alors que ce film remplit exactement l'espace séparant les composants adjacents en couvrant notamment les flancs ou faces latérales desdits composants.

En considérant par exemple, une utilisation de la matrice de composants dans un détecteur matriciel, une hybridation de celle-ci à un substrat (par exemple par la technologie bien connue dite de « *flip-chip* »), suivie d'un retrait de la base de substrat, il est obtenu une matrice de composants électroniques reliés par des ponts en matériau fonctionnel de largeur exactement égale à celle des tranchées.

De nombreuses applications sont alors possibles.

Par exemple, il est envisageable d'utiliser les ponts ainsi réalisés pour résoudre des problèmes de déplacement relatif entre des composants adjacents en choisissant des ponts élastiques (par exemple en choisissant une épaisseur faible pour ceux-ci). Ceci est particulièrement avantageux dans le cas où les ponts sont également utilisés comme des interconnexions électriques entre des composants. En effet, ces interconnexions resteront assurées quelle que soit l'amplitude des déplacements relatifs entre des composants adjacents. Par exemple, en choisissant une faible épaisseur de pont, ce dernier se comportera comme une lame ou un film souple, dont l'amplitude de déformation est importante et généralement supérieure à l'amplitude des déplacements relatifs que peuvent connaître les composants électroniques lors de leur utilisation.

Par exemple, si le matériau fonctionnel est conducteur, les ponts peuvent servir à l'interconnexion électrique des composants. Cette interconnexion électrique peut être réalisée sur le flanc des composants, laissant alors libre la surface supérieure de ceux-ci.

Dans un autre exemple d'application, si les ponts sont réalisés en matériau opaque, il est obtenu une isolation optique parfaite des composants, ce qui évite donc un bruit parasite connu sous le terme de « *cross-talk* », usuellement rencontré dans les détecteurs matriciels. En effet, aucun rayonnement ne peut atteindre les tranchées qui sont protégées par les ponts. Le rayonnement détecté correspond donc exactement au rayonnement incident sur les surfaces de détection des composants électroniques.

On notera par ailleurs que l'invention met finalement en oeuvre ce qui était usuellement considéré comme un défaut dans le domaine de la fabrication de dispositifs matriciels micrométriques.

La formation de motifs fonctionnels à la surface de composants électroniques séparés par des tranchées, comme par exemple des zones de métallisation, est usuellement réalisée par une technique soustractive à base de rayonnement. Le terme de soustractif renvoie ici à la notion selon laquelle, une couche étendue de matériau fonctionnel est déposée sur la surface des composants, et que le surplus de matériau fonctionnel est éliminé pour former les motifs. On peut notamment citer à cet égard la photolithographie.

En prenant l'exemple de cette technique, la couche étendue de matériau fonctionnel est recouverte d'une résine photosensible, puis un rayonnement ultraviolet (UV) est appliqué sur celle-ci au travers d'un masque de soustraction définissant les portions de couche de matériau à éliminer pour former les motifs fonctionnels. Sous l'effet du rayonnement UV, la portion de résine positive exposée subit une transformation chimique qui permet son élimination par un processus de développement à l'aide d'une solution basique.

Une fois le développement réalisé, les portions de la couche de matériau devant être éliminées sont donc affleurantes et sont éliminées par gravure chimique. Dans le même temps, la résine non exposée n'a pas été éliminée par le développement et protège donc le matériau des motifs de la gravure. Une fois cette portion de résine non exposée éliminée par un bain chimique, les motifs fonctionnels désirés apparaissent donc à la surface des composants électroniques.

Or, comme cela est connu, pour former des motifs micrométriques par masquage, la longueur d'onde du rayonnement doit être inférieure aux dimensions des motifs, notamment pour éviter des phénomènes de diffraction lors de la traversée du masque. D'où l'utilisation d'un rayonnement ultraviolet pour la formation de motifs micrométriques. Or, plus la longueur d'onde d'un rayonnement est faible, plus le pouvoir de pénétration du rayonnement dans la résine, ou profondeur de champ, est faible.

Comme la résine remplissant les tranchées présente une épaisseur importante, elle n'est pas exposée dans son intégralité et ne peut donc être totalement éliminée par développement. Ainsi, un matériau non désiré au fond des tranchées ne peut être éliminé par la gravure chimique consécutive à l'exposition.

Jusqu'alors, on a donc évité tout dépôt de matériau fonctionnel dans les tranchées, dites profondes, considérant qu'il serait impossible de l'éliminer par la gravure.

L'invention utilise donc avantageusement ce qui était donc considéré dans l'état de la technique comme un défaut pour fabriquer des éléments de liaison recouvrant exactement les tranchées, en déposant sciemment du matériau fonctionnel en fond de tranchée.

Selon l'invention, le procédé comporte une ou plusieurs des caractéristiques avantageuses suivantes :
■ le matériau fonctionnel est élastique et/ou conducteur et/ou opaque, fonction des applications envisagées ;
■ l'étape d'exposition comporte une étape d'application d'un masque de photolithographie en surface de la résine photosensible ;
■ le masque de photolithographie comporte des portions de recouvrement des tranchées ;
■ l'étape d'exposition comporte une étape de sélection d'une profondeur de champ du rayonnement d'exposition de la résine, inférieure à la profondeur des tranchées, et supérieure à l'épaisseur de la pellicule de résine recouvrant la face supérieure des composants électroniques ;
■ l'étape de réalisation de la couche active est suivie d'une étape consistant à déposer et/ou implanter sur la surface libre de ladite couche active des éléments fonctionnels caractéristiques desdits composants ;
■ l'étape de dépôt et/ou d'implantation d'éléments fonctionnels comporte une étape de dépôt et/ou d'implantation d'une électrode et/ou d'une couche de métallisation permettant l'hybridation de chaque composant ;
■ la couche active est une couche semi-conductrice d'un premier type, et l'étape de dépôt et/ou d'implantation d'éléments fonctionnels comporte une étape de formation d'une zone semi-conductrice d'un second type pour chaque composant dans la surface libre de la couche active ;
■ l'étape d'individualisation desdits composants par formation de tranchées comprend, ou est suivie, d'une étape de formation d'une zone semi-conductrice du second type dans au moins une face latérale de chaque composant ;
■ l'étape de formation des zones semi-conductrices du second type dans lesdits bords latéraux est réalisé par dopage, notamment du type « *loophole* » (le dopage du type « *loophole* » est une gravure par bombardement ionique qui dope simultanément le matériau) ;
■ le matériau fonctionnel est métallique, et le masque de photolithographie est sélectionné de manière à former une couche métallique en surface des zones semi-conductrices du second type formées à la surface libre de la couche active ;
■ le procédé comporte une étape de réalisation d'un plot conducteur en surface de chacune desdites couches métalliques ;
■ le procédé comporte, consécutivement à l'étape de développement, une étape d'hybridation de la matrice sur un substrat.

L'invention a également pour objet une matrice d'au moins deux composants électroniques individualisés dans une couche active au moyen de tranchées traversantes formées dans celle-ci.

Selon l'invention, cette matrice comporte, pour chaque paire de composants électroniques adjacents, au moins un élément relié auxdits composants, recouvrant au moins partiellement la tranchée séparant lesdits composants, et comportant au moins un point de contact avec chacune des parois latérales définissant ladite tranchée.

En d'autres termes, l'élément de liaison entre des composants adjacents comprend au moins une portion s'étendant sur toute la largeur de la tranchée. L'espace inter - composants est dont utilisé de manière optimale.

Selon des modes de réalisation particuliers, la matrice comporte une ou plusieurs des caractéristiques suivantes :
■ chaque composant présente une forme globalement de polygone régulier, notamment une forme parallélépipédique à base rectangulaire, hexagonale, triangulaire ou autres ;
■ l'élément de liaison est opaque ;
■ l'élément de liaison présente une élasticité susceptible de conserver l'intégrité de la connexion électrique avec un composant adjacent malgré un déplacement relatif entre composants ;
■ l'élément de liaison est conducteur ;
■ l'élément de liaison est filiforme ;
■ l'élément de liaison est surfacique ;
■ l'élément de liaison est en contact avec une reprise de contact électrique du ou des composants ;
■ ladite reprise de contact est réalisée sur l'une des faces latérales ou sur l'une des faces transversales du composant considéré :
■ l'élément de liaison est constitué de plusieurs couches, dont une couche de conduction électrique et une couche de cohésion destinée à permettre l'assemblage sur la reprise de contact ; la couche externe est avantageusement constituée d'un matériau choisi dans le groupe comprenant le titane (Ti), le chrome (Cr) ainsi qu'un alliage (TiW) de titane et de tungstène, et la couche de conduction est avantageusement constituée d'un matériau choisi dans le groupe comprenant le platine, l'or, l'aluminium, le cuivre ou un alliage de cuivre et de béryllium ;
■ l'élément de liaison est commun à tout ou partie desdits composants et forme une ligne ou une grille continue.
■ chaque composant électronique est un transistor bipolaire, dont au moins une zone semi-conductrice est formée dans l'une des faces latérales de celui-ci et est en contact avec ledit élément de liaison.

L'invention a également pour objet un procédé de réalisation d'un dispositif électronique comprenant une pluralité de composants électroniques rapportée sur un substrat.

Selon l'invention, ce procédé consiste :
■ à réaliser une couche active par épitaxie sur une strate sacrificielle ;
■ à déposer et/ou implanter sur la surface libre de ladite couche active des éléments fonctionnels caractéristiques desdits composants, tels qu'une électrode, notamment une anode, et/ou une couche de métallisation permettant l'hybridation de chaque composant ;
■ à graver des tranchées en lignes et/ou en colonnes dans ladite couche active au moins jusqu'à dégager ladite strate, de manière à individualiser lesdits composants au sein d'une matrice ;
■ à réaliser un plot électriquement conducteur sur au moins l'une des faces libres de chaque composant ainsi individualisé, de manière à réaliser des reprises de contact ;
■ à réaliser par dépôt au moins un film électriquement conducteur s'étendant sur lesdites tranchées de manière à connecter au moins deux à deux lesdites reprises de contact de composants adjacents, ledit film présentant une épaisseur déterminée pour lui conférer une élasticité susceptible de maintenir la connexion électrique malgré un déplacement relatif entre composants ;
■ à hybrider les composants sur le substrat ;
■ à amincir sélectivement les faces de chaque composant situées en regard dudit substrat, de manière à laisser en saillie tout ou partie desdits éléments fonctionnels ;
■ à éliminer ladite strate au moyen d'un usinage mécanique ou d'une attaque chimique, de manière à dégager le film électriquement conducteur,
lesdites étapes de réalisation de la couche active, de gravure de tranchées et de dépôt du au moins un film étant conformes au procédé précité.

Selon des modes de réalisations particuliers de l'invention, le procédé comporte un ou plusieurs des caractéristiques suivantes :
Ainsi, avantageusement, l'étape de dépôt consiste :
   ■ à déposer une couche en matériau électriquement isolant recouvrant toute la surface de ladite couche active, à savoir celle de la tranchée et celle desdits composants ;
   ■ à percer ladite couche en matériau électriquement isolant au moyen d'une photolithographie suivie d'une gravure opérée au fond et sur tout ou partie des bords de ladite tranchée ;
   ■ à déposer ledit film électriquement conducteur sur toute ou partie de la surface libre desdits composants et desdites tranchées ;
   ■ à ôter localement ledit film électriquement conducteur par gravure des surfaces desdits composants.

En outre, et avantageusement, le conducteur mis en oeuvre est constitué de plusieurs couches, dont une couche de conduction électrique et une couche de cohésion destinée à permettre l'assemblage sur la reprise de contact, l'étape d'élimination étant effectuée sous un plasma sélectionné de manière à être inerte au moins vis-à-vis de ladite couche de conduction.

L'invention a également pour objet un dispositif électronique comprenant une pluralité de composants électroniques rapportés sur un substrat, chaque composant étant mécaniquement relié audit substrat par l'intermédiaire d'un élément de liaison, dans lequel chaque composant est en outre électriquement connecté à au moins un composant adjacent au moyen d'au moins une pièce formant un conducteur. Selon l'invention, les composants et leurs conducteurs associés forment une matrice du type précité.

Selon des modes de réalisation particuliers, le dispositif comporte une ou plusieurs des caractéristiques suivantes :
■ la reprise de contact est réalisée sur la face du composant opposée à la face du composant rapportée sur le substrat ;
■ la reprise de contact est réalisée sur la face du composant rapportée sur ledit substrat.

L'invention a également pour objet un détecteur de rayonnement électromagnétique, tel que des rayons X, infrarouges ou de lumière visible. Selon l'invention, un tel détecteur comprend une matrice formée par un dispositif tel que précédemment décrit, dans laquelle chaque composant comprend un matériau apte à interagir avec ce rayonnement.

L'invention a également pour objet un émetteur de rayonnement électromagnétique, tels que des rayons laser, comprenant une matrice formée par un dispositif tel que précédemment décrit, dans laquelle chaque composant est constitué d'un émetteur laser à cavité verticale émettant par la surface (VCSEL) ou d'une diode électroluminescente (LED).

### BREVE DESCRIPTION DES FIGURES

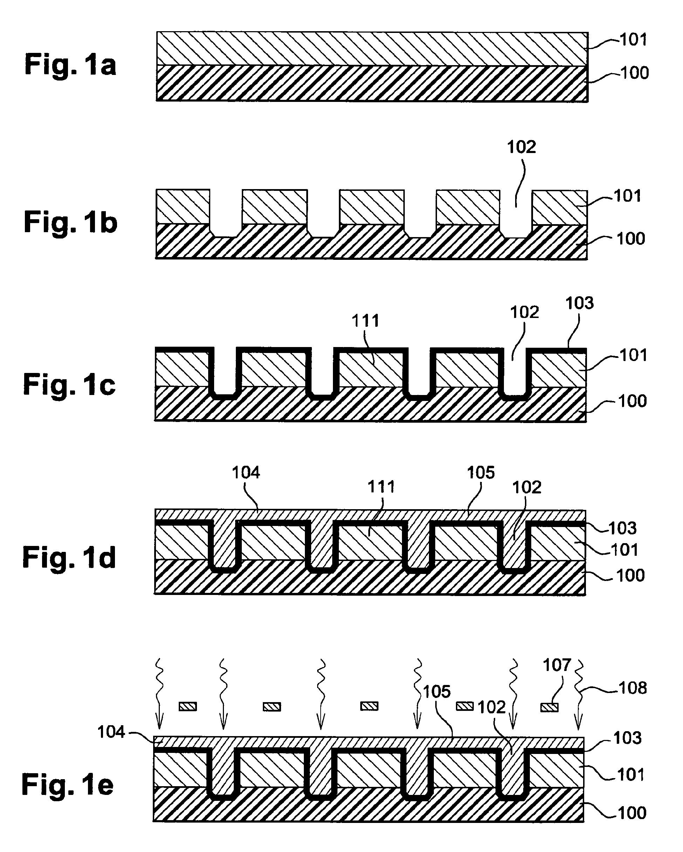

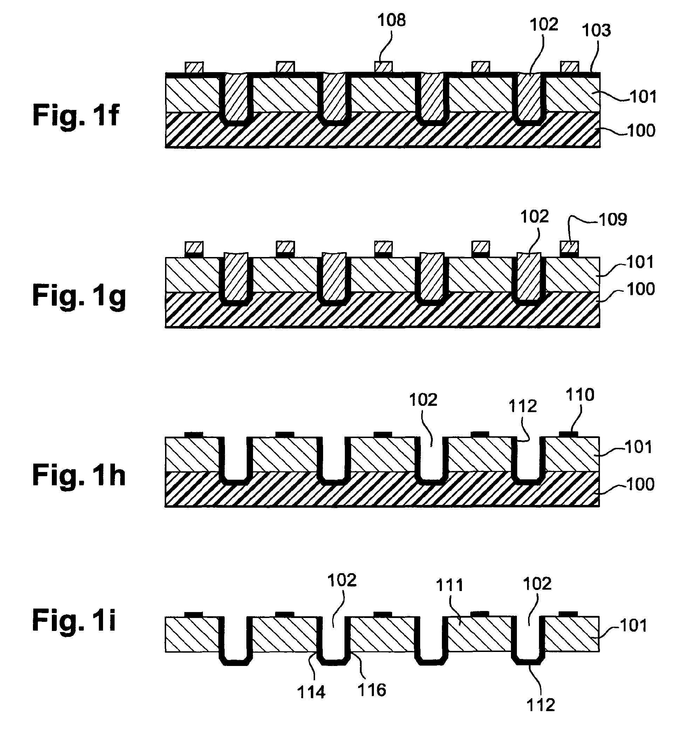

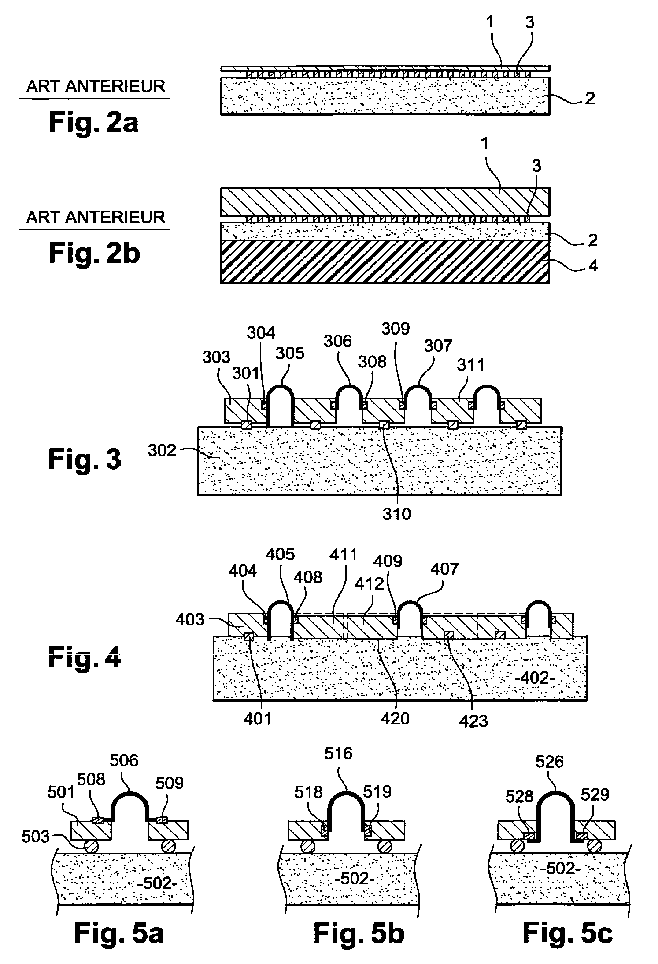

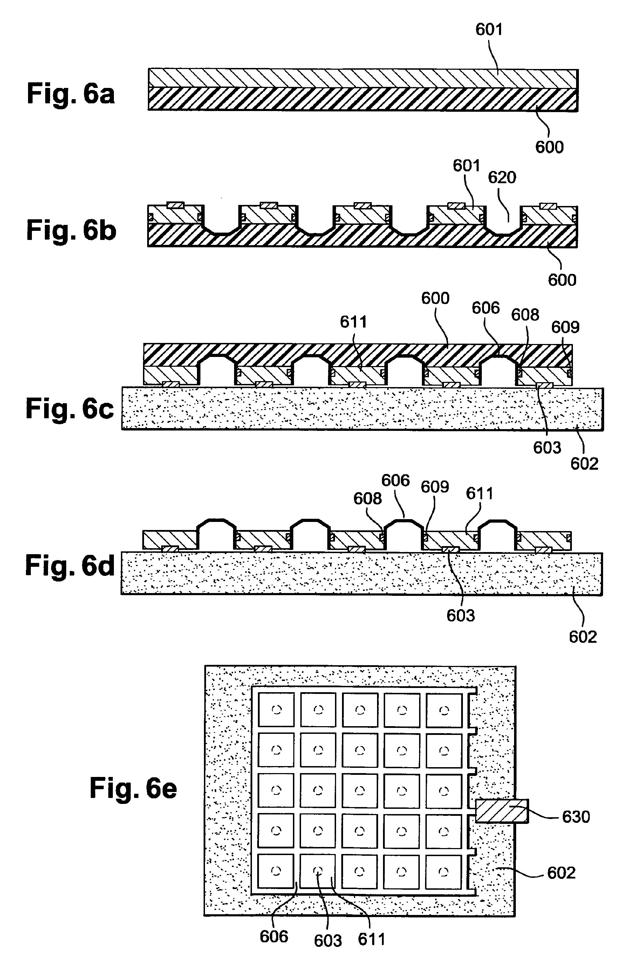

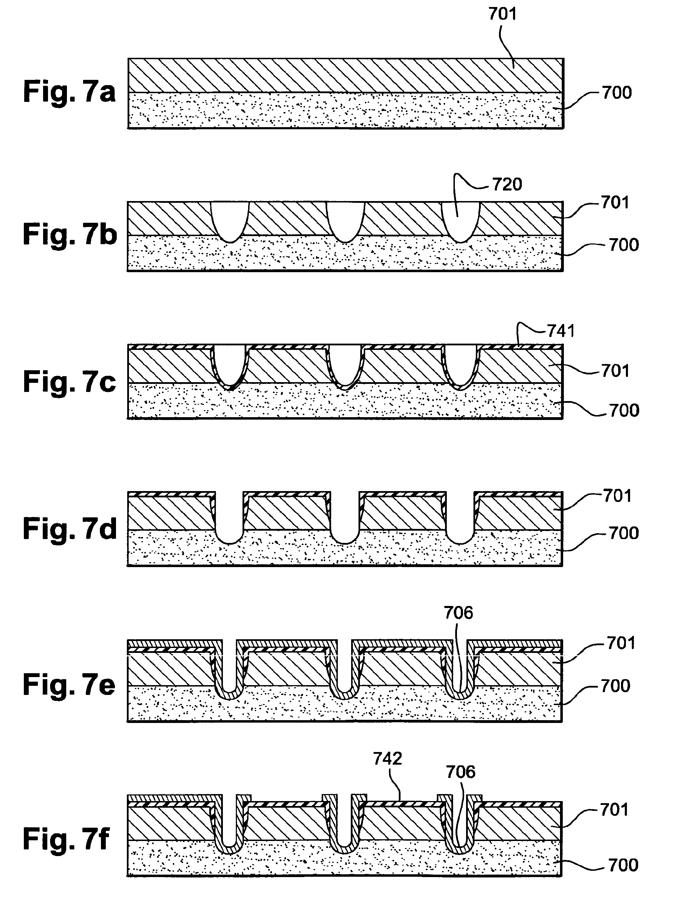

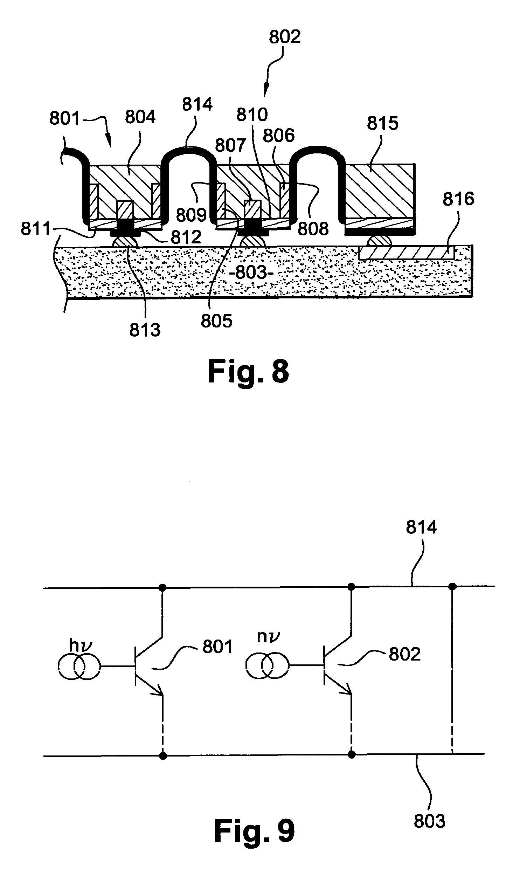

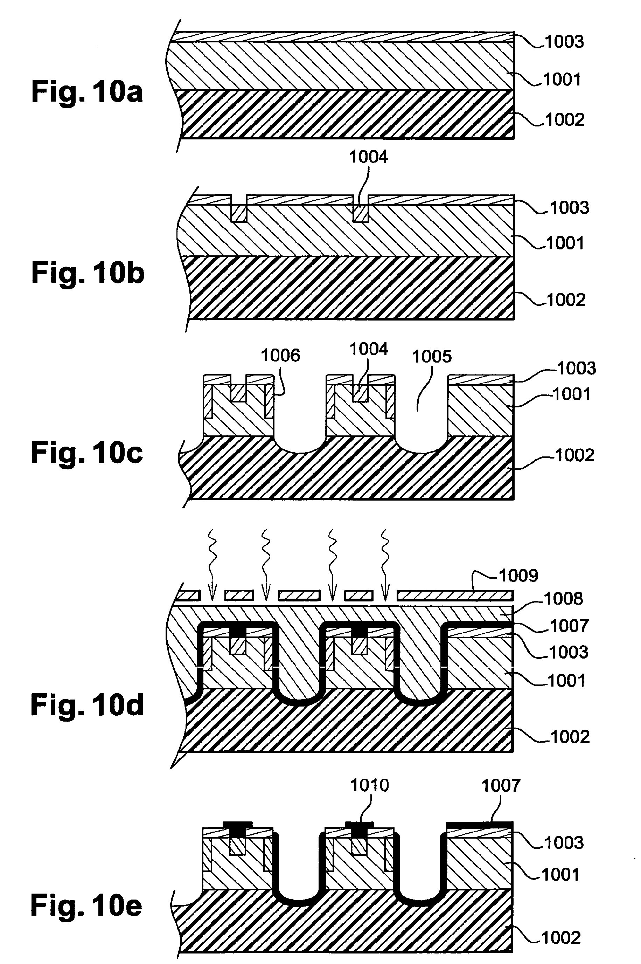

L'invention sera mieux comprise à la lecture de la description qui va suivre, donnée uniquement à titre d'exemple, et réalisée en relation avec les dessins annexés, dans lesquels des références identiques se rapportent à des éléments identiques ou analogues, et dans lesquels :
■ les figures 1a à 1h illustrent un procédé de fabrication de composants électroniques individuels reliés par des ponts, conformément à l'invention ;
■ la figure 1i est une vue schématique d'une matrice de composants électroniques selon l'invention ;
■ les figures 2a et 2b sont des représentations schématiques en section d'un dispositif électronique de l'art antérieur ;
■ la figure 3 est une représentation schématique en section d'un premier dispositif électronique comprenant une matrice de composants électroniques conforme à l'invention ;
■ la figure 4 est une représentation schématique en section d'un second dispositif électronique comprenant une matrice de composants électroniques conforme à l'invention ;
■ les figures 5a à 5c sont des représentations schématiques en section de dispositifs comprenant une matrice de composants électroniques conforme à l'invention présentant chacune une variante de localisation des reprises de contact électrique ;
■ les figures 6a à 6d sont des représentations schématiques en section illustrant différentes étapes du procédé de fabrication des dispositifs des figures 3 et 4 ;
■ la figure 6e est une représentation en vue de dessus du dispositif électronique illustré par la figure 6d ;
■ les figures 7a à 7f sont des représentations schématiques en section de certaines étapes d'une forme de réalisation du procédé de fabrication des dispositifs des figures 3 et 4 ;
■ la figure 8 est une représentation schématique en section d'un troisième dispositif électronique comprenant une matrice de composants électroniques conforme à l'invention ;
■ la figure 9 est une représentation électronique du dispositif de la figure 8 ; et
■ les figures 10a à 10e illustrent un procédé de fabrication du dispositif de la figure 8.

### DESCRIPTION DETAILLEE DE L'INVENTION

### FORME DE REALISATION DU PROCEDE SELON L'INVENTION

Les figures 1a à 1h illustrent différentes étapes successives d'une forme de réalisation du procédé de réalisation d'une matrice de composants électroniques micrométriques selon l'invention. Conformément à l'invention, le procédé consiste tout d'abord à réaliser (figure 1a) une couche active **101,** par exemple par épitaxie, sur une base de substrat **100.** La couche **101** est dite active, car elle est nécessaire à la fonction principale des composants électroniques à réaliser. La couche **101** est par exemple en matériau dit de détection ou d'émission comme le CdHgTe, InSb, AsGa, Si, Ge ou encore des multipuits quantiques.

On procède alors à la gravure (figure 1b) de tranchées **102** en lignes et en colonnes au sein de la couche active **101,** au moins jusqu'à dégager la base de substrat **100,** de manière à individualiser des composants **111** au sein de la matrice à réaliser. La gravure est par exemple une gravure par usinage ionique, une gravure plasma réactive ou une gravure chimique.

On dépose alors (figure 1c) un film d'un matériau fonctionnel **103,** par exemple par la technique dite de « *liftoff* »*,* sur la surface de la couche active **101** ainsi gravée. Le film **103** est par exemple constitué de TiPdAu, TiNiAu, TiPt, CrPdAu, OrNiAu, CrPt, Al, CuBe. Dans certains cas, la couche formant le film peut être composée de matériaux différents, par exemple un premier matériau au fond des tranchées, choisi pour sa bonne élasticité, et un deuxième matériau en surface, choisi pour son aptitude à être soudé.

On dépose (figure 1d) une résine photosensible **104** sur le film fonctionnel **103** de manière à remplir les tranchées **102** et à former une pellicule mince **105** sur la face supérieure des composants **111.** Le qualificatif mince renvoie ici à la notion selon laquelle l'épaisseur de la pellicule est suffisamment faible pour que le rayonnement utilisé pour une modification chimique de la résine, nécessaire à son développement, pénètre entièrement dans la pellicule **105** de sorte que les portions de pellicule exposées soient éliminées totalement lors du développement ultérieur.

On applique (figure le) un masque de photolithographie **107** en regard de la résine **104,** et l'on soumet l'ensemble à un rayonnement ultraviolet **104** au travers du masque **107.** La profondeur de champ du rayonnement ultraviolet est choisie pour pénétrer la pellicule **105** sur toute son épaisseur, mais en revanche, pas la résine sur toute sa hauteur à l'intérieur des tranchées **102.** Comme cela est connu en soi du domaine de la photolithographie, seules les portions de résine correctement exposées subissent une réaction chimique. Les portions sous-exposées, comme celles situées en dessous du masque **107** et celles remplissant les tranchées **102** ne subissent pas une telle réaction.

Dans l'exemple de la figure 1e, les tranchées ne sont pas masquées. En variante, le masque de photolithographie **107** masque lesdites tranchées **102.** Il n'est ainsi pas besoin de contrôler le rayonnement pour définir avec précision la profondeur de champ de celui-ci.

Une fois cette exposition réalisée, on développe (figure 1f) la résine exposée correctement. A l'issue de cette étape, seules les portions de résine masquées **109** par le masque **107** et celles remplissant les tranches **102** demeurent.

On grave alors (figure 1g) par attaque chimique les portions du film fonctionnel **103** laissées affleurantes par la disparition de résine, en suite de l'étape de développement, puis on ôte (figure 1 h) la résine résiduelle par un bain chimique.

A l'issue de cette étape, il existe donc, entre deux composants **111** adjacents, un pont **112** suivant exactement les parois des tranchées **102,** ainsi qu'une zone de film **110** sur la face supérieure de chaque composant **111.**

On notera qu'il importe peu dans certaines applications de maîtriser de manière précise la profondeur de pénétration du rayonnement UV dans la résine des tranchées. Ce qui importe, c'est qu'à la fin du processus de développement, il demeure une pellicule de résine protectrice **104** sur le film **103** déposé dans les tranchées **102.**

Il a été décrit un mode de réalisation du procédé dans lequel une zone de film à matériau fonctionnel est réalisée sur la face supérieure de chaque composant **111.**

Ce mode de réalisation est particulièrement utile pour réaliser des connexions électriques multiples. En effet, en choisissant un matériau fonctionnel conducteur, il est ainsi obtenu une interconnexion par pont entre chaque paire de composants **111** adjacents ainsi qu'une zone de connexion sur la face supérieure de chaque composant **111.**

Dans le cas où il n'est pas souhaité de conserver une zone de matériau fonctionnel sur la face supérieure des composants **111,** le masque de photolithographie **107** utilisé lors de l'étape d'exposition est inutile. Une exposition de toute la surface de la résine **104** est alors réalisée, et une fois le développement de la résine effectué, une gravure de la totalité de la face supérieure des composants est mise en oeuvre.

De même, il a été décrit un mode de réalisation, dans lequel aucune fonctionnalisation des composants, hormis les zones **110** de film, n'est réalisée. Des étapes intermédiaires peuvent être mises en oeuvre en fonction des besoins pour déposer ou implanter d'autres éléments fonctionnels caractéristiques des composants comme cela sera décrit dans les exemples d'application ci-dessous.

Conformément à l'invention et comme cela est illustré à la figure 1i, il est donc obtenu une matrice de composants électroniques **111** individualisés dans une couche active **101** au moyen de tranchées traversantes **102** formées dans celle-ci. La matrice selon l'invention comporte, pour chaque paire de composants électroniques adjacents **111,** au moins un élément **112** relié auxdits composants **111,** recouvrant au moins partiellement la tranchée **102** séparant lesdits composants, et comportant au moins un point de contact **114, 116** avec chacune des parois latérales définissant ladite tranchée **102.**

Les éléments **112,** à savoir des ponts dans l'exemple de la figure 1i, peuvent prendre des formes et des dimensions diverses en fonction de la forme des tranchées **102** gravées dans la couche active **101** et du processus de dépôt du film de matériau fonctionnel illustré à la figure 1c. Par exemple, le film peut être déposé de manière à former un élément filiforme.

La matrice de composants électroniques formée des composants **111** et des ponts **112** et obtenue au moyen du procédé selon l'invention, peut donner lieu à de nombreuses applications.

Elle peut être utilisée en tant que telle, en gardant ou pas la base de substrat **100,** et/ou hybridée sur des circuits électroniques.

D'autres caractéristiques et avantages de l'invention apparaîtront plus clairement en relation avec les applications décrites ci-dessous.

### PREMIERE APPLICATION PARTICULIERE DU PROCEDE ET DE LA MATRICE SELON L'INVENTION

Les figures 2 à 7 illustrent un exemple d'application de l'invention dans le domaine des dispositifs électroniques matriciels, dont les matrices de composants électroniques individualisés sont hybridées sur un substrat. Lesdites figures illustrent notamment une application à un détecteur matriciel, dont la matrice d'éléments détecteurs unitaires est rapportée sur un substrat de lecture.

Au cours de l'assemblage ou de l'utilisation de dispositifs électroniques, tels que ceux composant un détecteur matriciel, on peut rencontrer un problème de dilatation différentielle entre les éléments assemblés. On cherche à s'affranchir de tels phénomènes de dilatation différentielle survenant pendant l'assemblage ou l'hybridation des éléments, dans la mesure où ils altèrent le fonctionnement du dispositif électronique. En effet, ils conduisent généralement à la rupture des connexions électriques entre composants, en raison des contraintes thermomécaniques apparaissant lors du refroidissement du dispositif électronique assemblé.

Parmi les méthodes d'assemblage de composants microélectroniques avec un substrat décrites dans l'art antérieur, on a proposé des solutions à ces phénomènes de dilatation différentielle survenant au cours de l'assemblage, lequel est généralement effectué par soudure ou par brasure à température relativement élevée.

Néanmoins, si ces méthodes de l'art antérieur permettent de solutionner les dilatations différentielles survenant pendant l'hybridation du dispositif, les dispositifs microélectroniques ainsi assemblés ne tolèrent pas toujours les dilatations différentielles survenant pendant l'utilisation du dispositif microélectronique. Or, les températures d'utilisation d'un dispositif microélectronique peuvent différer sensiblement de la température à laquelle a été effectuée son hybridation.

Par conséquent, si le dispositif microélectronique assemblé selon l'une de ces méthodes de l'art antérieur est, peu ou prou, exempt de dilatation différentielle lors de son assemblage ou hybridation, il doit néanmoins supporter des contraintes mécaniques dues aux dilatations différentielles durant son utilisation. Ces contraintes peuvent même conduire à la rupture des connexions électriques entre éléments les constituant, et, partant, à la défaillance fonctionnelle de ce dernier.

Ainsi, il est possible d'assembler des composants électroniques à température ambiante limitant ou éliminant les contraintes résiduelles de dilatation, mais en raison de la température d'utilisation très basse, par exemple -200°C, à laquelle le dispositif peut être utilisé, les dilatations différentielles peuvent entraîner un déplacement relatif excessif entre composants, conduisant à la rupture de leurs connexions électriques, notamment au niveau des extrémités du dispositif microélectronique.

Deux solutions ont été proposées dans l'art antérieur pour rendre un tel dispositif microélectronique résistant aux contraintes mécaniques dues aux dilatations différentielles pendant la phase d'utilisation du dispositif. Ces deux solutions, similaires dans leur principe, sont illustrées respectivement par les figures 2a et 2b.

Dans l'exemple de la figure 2a, le dispositif électronique comprend un substrat **2,** formant par exemple un circuit de lecture pour un détecteur matriciel, et un ensemble **3** de composants électroniques, par exemple des « pixels » réalisés en matériau semi-conducteur, reliés mécaniquement et connectés électriquement par l'intermédiaire d'éléments de connexion **1** tels que des billes de brasure. L'assemblage illustré par la figure 2a peut par exemple être obtenu par la méthode d'assemblage bien connue sous l'expression anglo-saxonne « *flip-chip* ».

Dans le dispositif électronique illustré par la figure 2a, la couche de matériau formant l'ensemble de composants **1** est amincie de manière à réduire les contraintes mécaniques subies par les éléments de connexion **3** lors des dilatations différentielles au cours de la phase d'utilisation du dispositif. Si une telle structure à couche mince permet effectivement de limiter les risques de rupture des connexions électriques **3,** elle augmente en contrepartie les contraintes mécaniques et thermiques dans la couche mince **1,** ce qui revient en fait à déplacer le problème posé par de telles contraintes au niveau de cette couche.

Par conséquent, la couche **1** doit supporter des contraintes élevées et, partant, elle doit être dimensionnée et réalisée de façon minutieuse donc onéreuse. Ainsi, les matériaux qui la composent doivent être sélectionnés pour lui conférer la résistance à ces contraintes, sélection qui exclut d'emblée l'emploi de matériaux inappropriés limitant ainsi les fonctions électroniques que peut remplir une telle couche mince **1.**

La figure 2b illustre une autre solution de l'art antérieur qui consiste à amincir la couche en matériau **2,** constituant par exemple un substrat, et à lui superposer une couche **4.** Une telle structure permet de réduire sensiblement les contraintes subies par les connexions électriques **3,** mais, comme dans le cas de la figure 2a, cela revient à augmenter les contraintes mécaniques et thermiques s'exerçant pendant les phases d'utilisation sur la couche de matériau **2.** Outre les conséquences déjà évoquées en relation avec la figure 2a, cette structure obère encore le coût de fabrication.

En outre, un dispositif électronique présentant la structure d'un dispositif selon l'une des figures 2a ou 2b représente une limite à la miniaturisation de ses composants électroniques. En effet, dans la mesure où chaque pixel requiert un nombre déterminé de connexions électriques, le dispositif est tributaire de l'encombrement nécessaire à l'implantation des éléments **3** réalisant ces connexions électriques.

Ainsi, pour un nombre de détecteurs de rayonnement électromagnétique constitués par de tels dispositifs électroniques, chaque pixel doit comporter au moins deux connexions électriques, à savoir une connexion spécifique au pixel et une connexion commune à tous les pixels. Or, la tendance actuelle est à la miniaturisation des composants microélectroniques, notamment dans le domaine des détecteurs ou des émetteurs matriciels.

Il va maintenant être décrit des dispositifs et un procédé de fabrication de ceux-ci ne présentant pas les inconvénients de l'art antérieur venant d'être exposé. Ainsi, l'une des applications de l'invention se rapporte à un dispositif électronique, dont les connexions électriques ne présentent pas de risque de rupture en phase d'utilisation, d'une part, et dont la finesse des composants électronique n'est pas limitée par l'encombrement nécessaire à ces connexions électriques, d'autre part.

La figure 3 illustre une première forme de réalisation d'un dispositif électronique comprenant une pluralité de composants électroniques **303, 311** individualisés obtenus par le procédé selon l'invention, et qui sont rapportés sur un substrat **302.**

Dans l'exemple de la figure 3 comme dans les figures qui suivent, les composants électroniques **303, 311** sont composés d'un matériau apte à interagir avec un rayonnement électromagnétique à détecter, et par exemple un alliage de cadmium (Cd), de mercure (Hg) et de tellure (Te), propre à détecter les rayons infrarouges. Néanmoins, les composants électroniques peuvent être d'une autre nature et remplir d'autres fonctions, comme la détection ou l'émission d'autres rayonnements tels que les rayons X, visibles (LED), laser (VCSEL) etc. En fait, la plupart des détecteurs et émetteurs sont concernés.

Le substrat **302** peut quant à lui être constitué par un circuit semi-conducteur de type CMOS, comme c'est généralement le cas pour les détecteurs matriciels de rayonnement électromagnétique.

Chaque composant électronique **303, 311** est mécaniquement relié et électriquement connecté au substrat **302** par l'intermédiaire d'un élément de liaison **301, 310,** tel qu'une bille de brasure mise en oeuvre dans le cadre d'une méthode d'assemblage « *flip-chip* », ou tel qu'un plot en polymère électriquement conducteur. Ainsi, les éléments de liaison contribuent à assurer la cohésion mécanique de l'assemblage.

Dans le cas où le dispositif électronique sert à détecter un rayonnement électromagnétique, les éléments de liaison **301, 310** peuvent constituer les pôles anodiques de leurs composants électroniques respectifs. Ainsi, les porteurs de charge libérés lors des interactions entre photons et matière dans les composants **303, 311** peuvent être conduits vers le circuit de lecture **302.** Un tel détecteur de rayonnement électronique présente donc, de manière classique, des composants de forme globalement de polygone régulier, comme par exemple une forme parallélépipédique à base rectangulaire, carrée, hexagonale ou triangulaire, correspondant chacun à un pixel du détecteur matriciel.

Conformément à l'invention, chaque composant **303, 311** est en outre électriquement connecté à au moins un des composants qui lui est adjacent. Cette connexion électrique est réalisée au moyen d'au moins un conducteur **305-307** élastiquement déformable. Le conducteur **305-307** peut ainsi remplir la fonction de reprise de contact électrique au niveau d'une des surfaces de chaque composant électronique.

De plus, le conducteur **305-307** présente une élasticité telle qu'il est en mesure d'absorber des déformations dues aux contraintes thermomécaniques créées lors des dilatations différentielles des composants **303, 311** et du substrat **302.** En effet, comme exposé en relation avec l'état antérieur de la technique, en cas de différence de dilatation des matériaux constituant le substrat **302** et les composants **303,311,** on observe un déplacement relatif entre ces éléments. Ces contraintes comprennent essentiellement des contraintes en cisaillement, mais elles peuvent aussi comprendre des contraintes de fluage etc.

Dans l'exemple de la figure 3, le conducteur **305-307** présente sensiblement la forme d'une lame, c'est à dire qu'il a une épaisseur faible et une grande largeur considérée selon une direction perpendiculaire au plan de la figure 3. Ainsi, le conducteur **305-307** présente en fait le même potentiel électrique en tous points du détecteur illustré par la figure 3, car il présente la forme d'une grille à l'instar du dispositif illustré en vue de dessus par la figure 6e.

Le conducteur **305-307** revêt ainsi l'aspect d'un ruban ou d'un film continu réalisant un contact sur une surface étendue des flancs de chaque composant **303, 311.** Un tel contact surfacique présente l'avantage d'offrir une faible résistance électrique à l'écoulement des porteurs de charges vers le conducteur **305-307,** lequel peut former la cathode commune au dispositif de détection de la figure 3. Cela permet en conséquence de conserver un rapport signal sur bruit élevé en limitant la dégradation des signaux au niveau de chaque composant électronique du fait de la suppression des contraintes dans les matériaux actifs. De plus, cela permet une augmentation du rendement quantique du dispositif et la diminution de l'intermodulation électrique (courants de fuite) entre dispositifs voisins.

On reconnaît ici une matrice conforme à l'invention de composants électroniques individuels **303, 311** reliés par des ponts en matériau fonctionnel, ici les conducteurs **305-307.**

Par ailleurs, la reprise de contact du conducteur **305-307** sur les flancs **304, 308** et **309** de chaque pixel peut être réalisée directement ou par l'intermédiaire d'un moyen de connexion associé aux composants respectifs **303, 311.**

En pratique, le conducteur comprend au moins deux couches ; d'une part, une couche de cohésion permettant son assemblage avec le composant afférant au niveau de la reprise de contact et, d'autre part, une couche de conduction électrique assurant, par définition, le transfert des porteurs de charge au niveau d'un canal de collection commun à tout ou partie des pixels du détecteur.

La couche de cohésion ou « d'accrochage » est composée en l'occurrence de titane (Ti), mais elle pourrait être constituée d'un autre matériau connu pour ses propriétés de cohésion, tel que le chrome (Cr). La couche de conduction est quant à elle constituée d'un matériau bon conducteur électrique, tel que le platine (Pt), l'or (Au), l'aluminium (Al), le cuivre (Cu) ou un alliage de cuivre et de béryllium (CuBe).

Néanmoins, sans pour autant sortir du cadre de la présente invention, on peut envisager de réaliser le conducteur élastique en un matériau semi-conducteur. Cela permet de n'utiliser qu'un seul matériau pour réaliser les fonctions de conduction électrique et de cohésion mécanique.

La figure 4 illustre une deuxième forme de réalisation de l'invention dans laquelle des composants **403, 411, 412** sont connectés électriquement à un substrat **402** de type CMOS. De plus, les composants **403, 411, 412** sont mécaniquement reliés au substrat **402** par l'intermédiaire d'éléments de liaison **401, 423** insérés au fond des cavités **420** ménagées sur la surface du substrat **402.** De tels éléments de liaisons **401, 423** constituent ainsi une sorte de connecteur permettant la connexion à froid et évitant le chauffage nécessaire au soudage.

De plus, à l'instar du dispositif électronique illustré par la figure 3, un conducteur élastique **405, 407** permet de connecter électriquement des composants adjacents **403** et **411** entre eux. Comme dans le cas de la figure 3, le conducteur **405, 407** présente une élasticité supportant l'essentiel des contraintes thermomécaniques dues aux différences de dilatations entre les matériaux des éléments constituant le dispositif électronique de la figure 4.

A la différence du dispositif électronique représenté sur la figure 3, celui illustré par la figure 4 comprend des pixels accolés deux à deux **411, 412** constituant ainsi un bloc muni sur ses flans de reprise de contact **408-409** avec la conducteur **405, 407.** Cette forme de réalisation de l'invention permet de regrouper en « îlots » les composants **411, 412** et, partant, de diminuer le nombre de connexions et de simplifier le procédé de fabrication du dispositif électronique. En outre, cela permet d'augmenter la surface active. Toutefois, les composants électroniques **403** situés sur la zone périphérique du substrat **402** demeurent individualisés et présentent une reprise de contact **404** avec le conducteur **405.**

On reconnaît ici une matrice conforme à l'invention, comportant des composants électroniques individuels **403, 411** reliés par des ponts en matériau fonctionnel, ici les conducteurs **405-407.**

Les figures 5a, 5b et 5c illustrent respectivement une variante pour la reprise de contact des conducteurs élastiques **506, 516, 526** sur différentes faces des composants **501** formant le dispositif électronique.

Ainsi, sur la figure 5a, les reprises de contact **508, 509** sont réalisées sur les faces des composants **501** opposées à leur face rapportée sur le substrat **502.** Cela permet de limiter d'une part l'encombrement occupé par les connexions électriques sur la face inférieure d'un pixel et, d'autre part, d'augmenter la compacité des composants en réduisant l'intervalle nécessaire entre composants voisins.

Dans le cas de la figure 5c, les reprises de contact **528, 529** sont réalisées sur les faces des composants rapportés sur le substrat **502,** c'est-à-dire sur les faces inférieures situées en regard de ce substrat **502** et recevant les éléments de liaison notamment mécaniques, tels que les billes de brasure **503,** en particulier quand cette face présente déjà des reprises de contact. Cela permet de libérer le plus possible la face supérieure des composants.

La figure 5b illustre quant à elle une variante où les reprises de contact **518, 519** sont réalisées sur les flancs ou faces latérales de chaque composant, à l'instar des dispositifs électroniques représentés sur les figures 3 et 4. Une telle variante permet de libérer les surfaces supérieure et inférieure de chaque composant, maximalisant ainsi le volume « actif » pour la détection ou l'émission.

Les figures 6a à 6d illustrent différentes étapes successives d'une forme de réalisation du procédé de fabrication d'un dispositif électronique conforme à l'invention. Conformément à l'invention, le procédé illustré par les figures 6 consiste tout d'abord à réaliser une couche active **601** par épitaxie sur une strate sacrificielle **600 ;** la couche est dite active, car c'est elle qui remplit la fonction principale du composant, par exemple en interagissant avec les photons incidents pour libérer des porteurs de charges dans le cas des pixels d'un détecteur.

On dépose et/ou implante ensuite sur la surface libre de cette couche active **601** des éléments fonctionnels **603** caractéristiques des composants **611** ; en l'occurrence, il s'agit d'anodes individuelles et d'une couche de métallisation permettant l'hybridation de chaque composant **611.**

On procède alors à la gravure des tranchées **620** en lignes et en colonnes dans la couche active **601** au moins jusqu'à dégager la strate **600,** de manière à individualiser les composants **611** au sein d'une matrice.

On réalise un plot électriquement conducteur sur les flancs ou faces latérales des composants **611** individualisés, de manière à réaliser des reprises de contact **608, 609 ;** ces flancs peuvent être qualifiés de « libres », car ils sont dégagés du substrat.

On réalise alors par un dépôt, par exemple par la technique dite de « *liftoff* », un film **606** électriquement conducteur, s'étendant sur les tranchées **620** gravées, de manière à connecter entre elles les reprises de contact **608, 609** de composants **611** adjacents.

Conformément à l'invention, l'épaisseur de ce film **606** est déterminée pour lui conférer une élasticité susceptible de maintenir la connexion électrique malgré un déplacement relatif entre composants **611** en cas de différence de dilatation au sein du dispositif.

On hybride alors les composants **611** sur le substrat **602,** ici constitué d'un circuit CMOS, puis l'on amincit sélectivement les faces de chaque composant **611** situées en regard du substrat **602,** de manière à laisser en saillie les éléments fonctionnels **603.**

On élimine enfin la strate **600** au moyen d'une attaque chimique, de manière à dégager le film électriquement conducteur **606.**

On observe ainsi que les différentes étapes de réalisation de la couche active, de gravure de tranchées et de dépôt du film fonctionnel sont réalisées conformément au procédé selon l'invention, décrit en relation avec les figures 1a à 1h.

Par la suite, on peut prévoir d'ajouter un moyen de collecte **630** commun à tous les pixels du détecteur, de manière à former par exemple un canal cathodique de sortie.

Un tel procédé permet ainsi de fabriquer de manière simple et économique un dispositif électronique conforme à l'invention.

On peut ainsi appliquer ce procédé à une tranche (de l'anglais *wafer*) en CMOS issue d'une fonderie de silicium (Si), sur laquelle on réalise une hybridation collective de circuits de détections, ou capteurs, prétraités.

Pour réaliser l'attaque chimique de l'étape d'élimination de la strate **600,** on peut usiner mécaniquement la strate jusqu'à une épaisseur de in µm avant de graver au moyen d'un plasma fluoré la couche résiduelle de germanium jusqu'à parvenir au métal situé au fond de la tranchée **620.** Pour cela, il est souhaitable de protéger les autres parties exposées du dispositif électronique, tels que le circuit de lecture en CMOS, ou les bords des capteurs ou circuits de détection.

Les figures 7a à 7f illustrent une séquence d'étapes pouvant être réalisée dans le cadre du procédé décrit ci-dessus et consistant :
■ à déposer une couche en matériau électriquement isolant **741** recouvrant toute la surface la couche active **701,** à savoir celle d'une tranchée **720** issue de gravure et celle des composants **701 ;**
■ à percer ladite couche en matériau électriquement isolant **741** au moyen d'une photolithographie suivie d'une gravure opérée au fond et sur une partie des bords de cette tranchée **720** ; ainsi, la partie « supérieure » libre de chaque pixel est dépourvue de matériau isolant ;
■ à déposer un film électriquement conducteur **706** sur toute la surface libre des composants **701** et sur toute la surface des tranchées **720 ;**
■ à ôter localement le film électriquement conducteur **706** par gravure des surfaces des composants **701.**

Une telle séquence d'étapes permet de positionner la zone de reprise de contact entre le film conducteur **706** et les pixels **701** au fond de la tranchée **720** et donc, au niveau de la surface libre de chacun des composants **701,** c'est-à-dire la surface située à l'opposée de la face rapportée sur le substrat non représenté sur les figures 7. Ainsi, les reprises de contact sont éloignées de la partie active **701** d'un composant, limitant ainsi les risques de perturbations électriques, car une trop grande proximité induit des parasites électriques.

Il est ainsi possible de réaliser un détecteur matriciel de 2000 x 2000 pixels avec un pas compris entre 15 µm et 20 µm, ce qui constitue un détecteur carré de 4 cm de côté. Dans un tel détecteur les dilatations peuvent atteindre 18 µm selon la direction diagonale pour des températures descendant de l'ambiante à 77 K. Or, avec un tel pas de pixels, il est très difficile voire impossible de réaliser deux liaisons par composant c'est-à-dire par pixel, selon la manière conventionnelle illustrée par les figures 2a ou 2b. Il est cependant possible de fabriquer, à l'aide du procédé de fabrication de l'invention un dispositif électronique conforme à l'invention qui est complètement fonctionnel pour constituer un détecteur de rayonnement électronique.

Ainsi, lors d'une excursion de température, échauffement ou refroidissement, le comportement en dilatation du dispositif électronique de l'invention permet de transmettre les contraintes thermomécaniques au conducteur élastique. Chaque composant électronique suit individuellement le déplacement dû à la dilatation globale du matériau constituant le substrat.

De plus, les contraintes mécaniques et thermiques imposées localement par le substrat sur chaque composant électronique par l'intermédiaire du conducteur élastique sont relativement faibles et peuvent même être réduites à une valeur négligeable dans le cas où le matériau constituant le conducteur élastique est relativement tendre comme l'indium (In) et/ou dans le cas où le conducteur élastique est solidarisé à chaque composant au niveau du centre de la face qui le reçoit. Lors de la dilatation, c'est le conducteur élastique qui se déforme et « absorbe » localement les contraintes mécaniques dues à la dilatation différentielle entre composants et substrat.

Outre cet avantage important de résistance à la dilatation, le dispositif électronique de la présente invention permet de réduire, par exemple de deux à un, le nombre d'éléments de liaison mécanique et électrique nécessaires sur la face de chaque composant rapportée sur le substrat. Par conséquent, il est possible de miniaturiser un tel dispositif électronique.

Par ailleurs, un dispositif conforme à l'invention présente également l'avantage d'être intégrable, par exemple par collage sur toute sa surface, sur un support dont le coefficient de dilatation ne dépend pas du dispositif électronique. Ainsi, aucune contrainte mécanique exercée par un objet froid et plan sur le substrat de lecture n'est transmise aux pixels, car ceux-ci sont désormais mécaniquement découplés du substrat.
En tant que de besoin, il est aussi possible de déposer une couche antireflet sur le film conducteur élastique de manière à éviter de parasiter les signaux issus des photons directement incidents ou émis.

D'autres modes de réalisation de l'invention sont possibles sans pour autant sortir du cadre de cette invention. On peut ainsi remplacer, comme indiqué ci-dessus, les composants formant des pixels de détection par des émetteurs élémentaires de laser tels que des émetteurs à cavité verticale émettant par la surface (abrégé en VCSEL d'après l'anglais *Vertical Cavity Semi Conducteur Emitting Laser*) ou des diodes électroluminescentes (acronyme anglais *LED).*

En d'autres termes, dans le cadre de la résolution des problèmes exposées en relation avec les figures 2a et 2b, l'application venant d'être décrite de l'invention à un dispositif électronique matriciel, dont la matrice de composants électroniques individualisés est hybridée sur un substrat de lecture, peut se résumer comme suit.

Tout d'abord, cette application concerne un dispositif électronique, dont les éléments constitutifs, composant et/ou substrat, subissent des contraintes thermomécaniques relativement faibles, dont les connexions électriques résistent aux dilatations différentielles notamment en phase d'utilisation et ne constituent pas une limite à la miniaturisation des composants électroniques.

Le dispositif électronique objet de cette application comprend une pluralité de composants électroniques individualisés rapportés sur un substrat, chaque composant étant mécaniquement relié au substrat par l'intermédiaire d'un élément de liaison. Chaque composant est en outre électriquement connecté à au moins un composant adjacent au moyen d'au moins un conducteur remplissant la fonction de reprise de contact électrique, ledit conducteur présentant une élasticité susceptible de conserver la connexion électrique malgré un déplacement relatif entre composants.

En d'autres termes, les composants électroniques sont tous mutuellement connectés électriquement au moyen d'au moins un conducteur « souple » reprenant les contraintes thermomécaniques dues aux dilatations différentielles entre éléments du dispositif. De plus, un tel conducteur remplit la fonction de reprise de contact électrique entre les composants électroniques, ce qui permet de limiter à un le nombre d'éléments de liaison mécanique et électrique entre le substrat et chaque composant électronique. En conséquence, l'encombrement réduit nécessité par les éléments de liaison permet de miniaturiser les composants électroniques.

Selon une première forme de réalisation, ce conducteur peut être filiforme. Une telle structure du conducteur permet de réaliser des reprises de contact électriques peu encombrantes sur la surface de chaque composant électronique.

Ainsi, un simple « fil » peut relier deux composants électroniques voisins.

Selon une deuxième forme de réalisation, ce conducteur peut être surfacique. Par surfacique, on désigne une pièce de surface étendue, contrairement à une pièce filiforme. On peut ainsi qualifier de pièce surfacique un film, un ruban ou une plaque mince.

En d'autres termes, un tel conducteur permet une reprise de contact électrique sur une surface relativement étendue de chaque composant électronique, ce qui diminue la résistance électrique d'un tel contact.

En pratique, le conducteur peut être en contact avec une reprise de contact électrique.

Selon une forme de réalisation pratique, chaque composant peut présenter une forme globalement de polygone régulier, comme par exemple une forme parallélépipédique à base rectangulaire, carrée, hexagonale ou triangulaire.

Une telle forme permet de réaliser une matrice dans laquelle chaque composant joue le rôle d'un pixel.

Dans cette forme de réalisation pratique, la reprise de contact peut être réalisée sur l'une des faces latérales des composants.

Cela permet de connecter électriquement deux composants électroniques adjacents de manière relativement simple, donc économique. Par face latérale, on entend une face perpendiculaire à la face du composant située en regard du substrat.

Selon cette forme de réalisation pratique, la reprise de contact peut être réalisée sur la face du composant opposée à la face du composant rapportée sur le substrat ; autrement dit, sur la face supérieure du composant lorsque celui-ci est posé sur son substrat.

Une telle reprise de contact permet de réduire au maximum l'intervalle séparant deux composants électroniques et, partant, d'augmenter la compacité des composants.

Selon une autre variante de cette forme de réalisation pratique, la reprise de contact peut également être réalisée sur la face du composant rapportée sur le substrat, autrement dit, sur la face inférieure du composant lorsque celui-ci est posé sur son substrat. Cela est particulièrement intéressant lorsque la reprise de contact est déjà disponible sur cette face, par exemple en cas de dopage local approprié.

Selon une forme de réalisation, le conducteur peut être constitué de plusieurs couches, dont une couche de conduction électrique et une couche de cohésion destinée à permettre l'assemblage sur la reprise de contact.

Cette structure multicouche permet de dissocier les deux fonctions que doit remplir le conducteur, à savoir la conduction électrique entre composants et l'élasticité requise pour accepter les contraintes thermomécaniques de dilatation différentielle.

Ainsi, chacune des couches du conducteur est apte à remplir correctement l'une ou l'autre de ces fonctions.

En pratique, la couche externe peut être constituée d'un matériau choisi dans le groupe comprenant le titane (Ti), le chrome (Cr) ainsi qu'un alliage (TiW) de titane et de tungstène, et la couche de conduction peut être constituée d'un matériau choisi dans le groupe comprenant le platine (Pt), l'or (Au), l'aluminium (Al), le cuivre (Cu) ou un alliage de cuivre et de béryllium (CuBe).

De tels matériaux permettent de réaliser un conducteur remplissant convenablement ses fonctions.

Selon une forme de réalisation particulière, le conducteur est commun à tout ou partie des composants, le conducteur formant par exemple une ligne ou une grille continue.

Une telle caractéristique permet de réaliser le conducteur de façon relativement simple et économique, par exemple pour constituer la cathode d'un détecteur.

Par ailleurs, l'application concerne un détecteur de rayonnement électromagnétique, tel que des rayons X, infrarouges ou de lumière visible. Selon l'application, un tel détecteur comprend une matrice formée par un dispositif tel que précédemment décrit, dans laquelle chaque composant comprend un matériau apte à interagir avec ce rayonnement.

Un détecteur ainsi constitué peut présenter un degré élevé de miniaturisation tout en résistant aux contraintes thermomécaniques dues aux dilatations différentielles entre les éléments qui le constituent.

En pratique, le substrat de ce détecteur peut être constitué par un circuit à semi-conducteur de technologie type CMOS, et le matériau apte à interagir avec ledit rayonnement peut être un alliage de cadmium (Cd), de mercure (Hg) et de tellure (Te), du InGaAs, du InSb, du Si ou du Ge. Un tel détecteur présente des performances de détection compatibles avec une miniaturisation élevée.

D'autre part, l'application concerne un émetteur de rayonnement électromagnétique, tel que des rayons laser, comprenant une matrice formée par un dispositif tel que précédemment décrit, dans laquelle chaque composant est constitué d'un émetteur laser à cavité verticale émettant par la surface (VCSEL) ou d'une diode électroluminescente (LED).

Un émetteur ainsi constitué est susceptible de présenter un degré de miniaturisation élevé.

Par ailleurs, l'application concerne aussi un procédé de fabrication d'un dispositif électronique comprenant une pluralité de composants électroniques rapportée sur un substrat. Le procédé selon l'invention comporte la séquence d'étapes consistant :
■ à réaliser une couche active par épitaxie sur une strate sacrificielle ;
■ à déposer et/ou implanter sur la surface libre de cette couche active des éléments fonctionnels caractéristiques de ces composants, tels qu'une anode et/ou une couche de métallisation permettant l'hybridation de chaque composant ;
■ à graver des tranchées en lignes et/ou en colonnes dans cette couche active au moins jusqu'à dégager cette strate, de manière à individualiser ces composants au sein d'une matrice ;
■ à réaliser un plot électriquement conducteur sur au moins l'une des faces libres de chaque composant ainsi individualisé, de manière à réaliser des reprises de contact ;
■ à réaliser par dépôt, par exemple par la technique dite de *liftoff,* au moins un film électriquement conducteur s'étendant sur ces tranchées de manière à connecter au moins deux à deux les reprises de contact de composants adjacents, ce film présentant une épaisseur déterminée pour lui conférer une élasticité susceptible de maintenir la connexion électrique malgré un déplacement relatif entre composants ;
■ à hybrider les composants sur le substrat, tel qu'un circuit à semi-conducteur CMOS;
■ à amincir sélectivement les faces de chaque composant situées en regard du substrat, de manière à laisser en saillie tout ou partie de ces éléments fonctionnels ;
■ à éliminer la strate au moyen d'un usinage mécanique ou d'une attaque chimique, de manière à dégager le film électriquement conducteur.

En d'autres termes, après gravure des tranchées et réalisation des reprises de contact, le procédé objet de l'invention consiste à déposer un film propre à former un conducteur souple entre les composants et, éventuellement, le substrat.

En pratique, l'étape de dépôt peut comprendre la séquence d'étapes consistant :
■ à déposer une couche en matériau électriquement isolant recouvrant toute la surface de la couche active, à savoir celle de la tranchée et celle des composants ;
■ à percer la couche en matériau électriquement isolant au moyen d'une photolithographie suivie d'une gravure opérée au fond et sur tout ou partie des bords de ladite tranchée ;
■ à déposer le film électriquement conducteur sur toute ou partie de la surface libre des composants et des tranchées ;
■ à ôter localement le film électriquement conducteur par gravure des surfaces des composants.

Un tel procédé de fabrication permet de réaliser la reprise de contacts électrique au niveau de la partie libre de chacun des composants électroniques, de manière à limiter la dégradation du signal de chaque composant due aux perturbations et aux fuites de porteurs de charges entre pixels. On entend par « libre », la partie de la surface d'un composant qui n'est pas couverte par le substrat, donc ses faces latérales et supérieures.

Selon une forme de réalisation particulière, le conducteur peut être constitué de plusieurs couches, dont une couche de conduction électrique et une couche de cohésion destinée à permettre l'assemblage sur la reprise de contact. De plus, l'étape d'élimination peut être effectuée sous un plasma sélectionné de manière à être inerte au moins vis-à-vis de cette couche de conduction.

Cela permet de réaliser un conducteur de bonne qualité de façon relativement peu onéreuse.

Il a été décrit une application de l'invention dédiée à la fabrication d'un détecteur matriciel dans lequel les ponts **305, 307, 405, 407, 606** ont pour fonction de réaliser une interconnexion électrique entre des composants électroniques **303, 311, 403, 411, 611** adjacents et de sécuriser lesdites interconnexions en cas de déplacement relatif de ceux-ci.

En choisissant un matériau opaque pour ces ponts **305, 307, 405, 407, 606,** il est réalisé une isolation optique parfaite des composants photosensibles **303, 311, 403, 411.** Comme cela est visible à la figure 6e, on remarque que seules les faces supérieures des composants électroniques **611** sont libres d'être exposées à un rayonnement incident puisque l'espace entre ces composants est protégé optiquement par le pont **606.**

### DEUXIEME APPLICATION PARTICULIERE DU PROCEDE ET DE LA MATRICE SELON L'INVENTION

Les figures 8 à 10 illustrent une application analogue à celle décrite en relation avec les figures 2 à 7. La deuxième application diffère de la première essentiellement en ce que les composants électroniques sont des transistors bipolaires ou des diodes.

On comprendra donc que ce qui a été décrit en relation avec les figures 2 à 7 s'applique également à l'application décrit ci-dessous, moyennant, le cas échéant, des modifications mineures à la portée de l'homme du métier.

Sur la figure 8, il est représenté détecteur comportant une matrice de transistors bipolaires **801, 802** dans un agencement de collecteur commun hybridé sur un substrat de lecture **803.** Il sera considéré par la suite l'exemple de transistors NPN. Bien entendu ce qui suit s'applique également à des transistors PNP.

Chaque transistor **801, 802** est réalisé dans un bloc **804** en matériau apte à interagir avec un rayonnement électromagnétique à détecter et présentant un dopage P, par exemple un alliage de cadmium (Cd), de mercure (Hg) et de tellure (Te) dopé P, propre à détecter les rayons infrarouges.

Chaque transistor **801, 802** comporte en outre trois zones **805, 806, 807** formées dans le bloc **804,** dont les deux premières **805, 806** débouchent sur les faces latérales **808, 809** du transistor, et dont une troisième **807** débouche sur la face **810** du bloc **804** rapportée sur le substrat **803.** Les zones **805, 806, 807** sont formées dans le même matériau que celui du bloc **804,** à la différence qu'elles présentent un dopage N.

La face du bloc **804** rapportée sur le substrat **803** est par ailleurs recouverte d'une couche antireflet **811** comportant une ouverture **812** débouchant sur la troisième zone **807.** L'ouverture **807** est remplie d'un matériau conducteur, par exemple en platine (Pt) ou en or (Au).

Le substrat **803** est quant à lui être constitué d'un circuit de lecture semi-conducteur de type CMOS, comme c'est généralement le cas pour les détecteurs matriciels de rayonnement électromagnétiques.

Chaque transistor **801, 802** est mécaniquement relié et électriquement connecté au substrat **803** par l'intermédiaire d'un élément de liaison **813,** tel qu'une bille de brasure mise en oeuvre dans le cadre de la méthode d'assemblage « *flip-chip* », ou tel qu'un plot en polymère électriquement conducteur. Ainsi, les éléments de liaison contribuent à assurer la cohésion mécanique de l'assemblage.

Chaque transistor **802, 803** est en outre électriquement connecté à au moins l'un des transistors qui lui est adjacent au moyen d'au moins un conducteur **814** élastiquement déformable, et connecté à une zone latérale **805, 806** dopée N de chacun de ces transistors. Le conducteur **814** est conforme à celui décrit en relation avec les figures 3 à 7 et réalisé à l'aide du procédé selon l'invention.

Le conducteur **814** peut être ainsi filiforme ou surfacique. Le conducteur peut également être commun à tous les transistors et formé d'un seul tenant.

Enfin, la matrice comporte en chaque bout de ligne et/ou de colonne, un composant **815** assurant la reprise électrique du conducteur **814** du transistor qui lui est adjacent avec une zone de connexion de collecteur de mode commun du substrat de lecture **803.**

Les zones dopées N **805, 806, 807** et le bloc **804** dopé P de chaque transistor **801, 802** forment ainsi des jonctions PN et NP constitutives d'un transistor bipolaire. Les transistors bipolaires ainsi formé ont en outre leur collecteur relié en commun par les conducteurs **814.** Un conducteur **814** entre deux transistors adjacents est donc en reprise de contact sur des faces latérales de ceux-ci.

Les bases des transistors sont quant à elles flottantes et sujettes au rayonnement. Le schéma électronique équivalent à la matrice de la figure 8 est représenté à la figure 9.

En variante, la zone **807** n'est pas dopée par rapport au bloc **804.** Il est ainsi obtenu une configuration simplifiée du type diode.

Un procédé de fabrication du dispositif de la figure 8 est illustré au sein des figures 10a à 10e, et comprend la séquence d'étapes consistant à :
■ former par épitaxie une couche active **1001** de type P sur une strate sacrificielle **1002;**
■ former par épitaxie une couche **1003** en un matériau antireflet sur la face libre de la couche active **1001 ;**
■ former pour chaque transistor, une zone **1004** de type N dans la couche active **1001,** par exemple au moyen d'une implantation ou d'un usinage ionique ;
■ graver des tranchées **1005** autour des zones **1004** de type N, de manière à former une matrice de transistors individuels, et former dans les flancs ou les faces latérales des transistors individuels des zones **1006** de type N, de manière à former les collecteurs desdits transistors. Dans le cas particulier du CdHgTe, la gravure et la formation des zones **1006** sont par exemple réalisées simultanément au moyen de la technique dite de « *loophole* » décrite dans le document « Summary of HgCdTe 2D array technologie in the UK » de Baker I.M. et Maxey C.D., Journal of Electronic Materials, vol. 90, N° 6, 2001 ;
■ réaliser une métallisation bicouche **1007** sur toute la surface de l'ensemble gravé, de manière à former un film conducteur et élastique par une technique dite de « *liftoff* » ; cette métallisation **1007** consiste par exemple à réaliser un dépôt d'une première couche de contact et d'accrochage en titane ou en chrome, suivi du dépôt d'une seconde couche de conduction en platine ou en or, comme cela a été expliqué précédemment ;
■ recouvrir l'ensemble de résine photosensible et le soumettre à une exposition à un rayonnement UV au travers d'un masque de photolithographie masquant la résine recouvrant les zones de type N **1004** sur la face supérieure des transistors et la résine des tranchées ;
■ développer la résine exposée, graver la métallisation **1007** affleurante à la suite du développement et éliminer la résine résiduelle ;
■ hybrider l'ensemble sur un circuit de lecture CMOS à l'aide de la technologie dite de « *flip-chip* » ; et
■ éliminer la strate **1002** au moyen d'une attaque chimique et/ou mécanique, de manière à dégager la métallisation des tranchées.

Les étapes de métallisation, de dépôt de résine, d'exposition, de développement et de gravure sont réalisées conformément au procédé selon l'invention décrit en relation avec les figures la à 1i.

De préférence l'élimination de la strate sacrificielle comporte les étapes consistant à :
■ amincir mécaniquement la strate sacrificielle **1002** de manière à laisser une couche résiduelle mince de strate au dessus de la métallisation des tranchées, par exemple inférieure à 10 micromètres ; et
■ graver en plasma fluoré la couche résiduelle de strate jusqu'à la métallisation des tranchées en prenant soin de protéger les autres parties du dispositif

Il est ainsi obtenu une matrice de transistors bipolaires présentant les avantages suivants :
■ la taille des pixels est réduite. En effet, une seule connexion est réalisée sur la face supérieure du dispositif ce qui donne un pas plus petit lorsqu'on constitue une matrice;
■ la résistance d'accès au transistor est réduite car la connexion aux transistors n'est pas réalisée au travers de la couche active. En outre la section efficace des connexions entre les transistors est augmentée du faite d'une surface importante du film conducteur entre ceux-ci ;
■ le film bicouche est opaque et souple ;
■ le film bicouche recouvre exactement les tranchées.

## Revendications

1. Procédé de réalisation d'une matrice de composants électroniques individuels (111 ; 611 ; 801), comportant une étape de réalisation d'une couche active (101 ; 601 ; 1001) sur une base de substrat (100 ; 600 ; 1002), notamment par épitaxie, et une étape d'individualisation desdits composants par formation de tranchée traversantes (102 ; 620 ; 1005), notamment par gravure, dans la couche active (101 ; 601 ; 1001), ladite étape d'individualisation aboutissant au moins au dégagement de la base du substrat (100 ; 600 ; 1002), ***caractérisé* en ce qu'**il comporte des étapes consistant à :
■ déposer une couche de matériau fonctionnel (103 ; 1007) sur la couche active (101 ; 1001) et dans les tranchées traversantes (102;620;1005) ;
■ déposer une résine (104 ; 1008) photosensible à un rayonnement prédéterminé sur la couche de matériau fonctionnel (103 ; 1007) de manière à remplir lesdites tranchées (102 ; 1005) et à former une pellicule mince (105) sur la face supérieure des composants électroniques (111) ;
■ exposer au moins partiellement la résine (104 ; 1008) audit rayonnement tout en sous-exposant la portion de résine remplissant les tranchées (102 ; 620 ; 1005) ;
■ développer la résine (104 ; 1008) de manière à éliminer la portion de celle-ci correctement exposée ;
■ éliminer la portion de couche de matériau fonctionnel (103 ; 1007) affleurante à la suite de l'étape de développement ; et
■ éliminer la portion de résine résiduelle.

2. Procédé de réalisation d'une matrice de composants électroniques individuels selon la revendication 1, ***caractérisé* en ce que** le matériau fonctionnel (103 ; 1007) est élastique et/ou conducteur et/ou opaque.

3. Procédé de réalisation d'une matrice de composants électroniques individuels selon l'une des revendications 1 et 2, ***caractérisé* en ce que** l'étape d'exposition comporte une étape d'application d'un masque de photolithographie (107 ; 1009) en surface de la résine.

4. Procédé de réalisation d'une matrice de composants électroniques individuels selon la revendication 3, ***caractérisé* en ce que** le masque de photolithographie (107 ; 1009) comporte des portions de recouvrement des tranchées.

5. Procédé de réalisation d'une matrice de composants électroniques individuels selon l'une quelconque des revendications précédentes, ***caractérisé* en ce que** l'étape d'exposition comporte une étape de sélection d'une profondeur de champ du rayonnement prédéterminé, inférieure à la profondeur des tranchées (102 ; 1005) et supérieure à l'épaisseur de la pellicule de résine (105) recouvrant la face supérieure des composants électroniques (111 ; 801).

6. Procédé de réalisation d'une matrice de composants électroniques individuels selon l'une quelconque des revendications précédentes, ***caractérisé* en ce que** l'étape de réalisation de la couche active est suivie d'une étape consistant à déposer et/ou implanter sur la surface libre de ladite couche active (101 ; 601 ; 1001) des éléments fonctionnels (603 ; 1004) caractéristiques desdits composants.

7. Procédé de réalisation d'une matrice de composants électroniques individuels selon la revendication 6, ***caractérisé* en ce que** l'étape de dépôt et/ou d'implantation d'éléments fonctionnels (603 ; 1004) comporte une étape de dépôt et/ou d'implantation d'une électrode et/ou d'une couche de métallisation permettant l'hybridation de chaque composant.

8. Procédé de réalisation d'une matrice de composants électroniques individuels selon la revendication 6, ***caractérisé* en ce que** la couche active (1001) est une couche semi-conductrice d'un premier type, et **en ce que** l'étape de dépôt et/ou d'implantation d'éléments fonctionnels comporte une étape de formation d'une zone semi-conductrice d'un second type (1004) pour chaque composant dans la surface libre de la couche active.

9. Procédé de réalisation d'une matrice de composants électroniques individuels selon la revendication 8, ***caractérisé* en ce que** l'étape d'individualisation desdits composants par formation de tranchées comprend, ou est suivie, d'une étape de formation d'une zone semi-conductrice du second type (1006) dans au moins une face latérale de chaque composant.

10. Procédé de réalisation d'une matrice de composants électroniques individuels selon la revendication 8, ***caractérisé* en ce que** l'étape de formation des zones semi-conductrices du second type dans lesdits bords latéraux est réalisée par dopage, notamment du type « *loophode* ».

11. Procédé de réalisation d'une matrice de composants électroniques individuels selon l'une quelconque des revendications 8 à 10 lorsqu'elles dépendent de la revendication 3, ***caractérisé*** en ce le matériau fonctionnel est métallique, et en ce que le masque de photolithographie est sélectionné de manière à former une couche métallique (1010) en surface des zones semi-conductrices (1004) du second type formées à la surface libre de la couche active.

12. Procédé de réalisation d'une matrice de composants électroniques individuels selon la revendication 11, ***caractérisé* en ce qu'**il comporte une étape de réalisation d'un plot conducteur (813) en surface de chacune desdites couches métalliques.

13. Procédé de réalisation d'une matrice de composants électroniques individuels selon l'une quelconque des revendications précédentes, ***caractérisé* en ce qu'**il comporte, consécutivement à l'étape de développement, une étape d'hybridation de la matrice sur un substrat (402 ; 502 ; 602 ; 803).

14. Matrice d'au moins deux composants électroniques (111 ; 303, 311 ; 403, 411, 412 ; 501 ; 601 ; 801, 802) individualisés dans une couche active (101) sur une base de substrat (100) au moyen de tranchées traversantes (102 ; 1005) formées dans la couche active (101) ***caractérisée* en ce qu'**elle comporte, pour chaque paire de composants électroniques adjacents, au moins un élément (112 ; 305, 307 ; 405, 407 ; 506, 516, 526 ; 606 ; 814) relié auxdits composants (111 ; 303, 311 ; 403, 411, 412 ; 501 ; 601 ; 801, 802), recouvrant au moins partiellement la tranchée (102 ; 1005) séparant lesdits composants, et comportant au moins un point de contact avec chacune des parois latérales définissant ladite tranchée (102; 1005).

15. Matrice selon la revendication 14, ***caractérisée* en ce que** chaque composant (111 ; 303, 311 ; 403, 411, 412 ; 501 ; 601 ; 801, 802) présente une forme globalement de polygone régulier, notamment une forme parallélépipédique à base rectangulaire.

16. Matrice selon l'une des revendications 14 et 15, ***caractérisée* en ce que** ledit élément (112 ; 305, 307 ; 405, 407 ; 506, 516, 526 ; 606 ; 814) est opaque.

17. Matrice selon l'une des revendications 14 à 16, ***caractérisée* en ce que** ledit élément (112 ; 305, 307 ; 405, 407 ; 506, 516, 526 ; 606 ; 814) présente une élasticité susceptible de conserver l'intégrité de la connexion électrique avec un composant adjacent malgré un déplacement relatif entre composants.

18. Matrice selon l'une quelconque des revendications 14 à 17, ***caractérisée* en ce que** ledit élément (112 ; 305, 307 ; 405, 407 ; 506, 516, 526 ; 606 ; 814) est conducteur.

19. Matrice selon la revendication 18, ***caractérisée* en ce que en ce que** ledit élément (112 ; 305, 307 ; 405, 407 ; 506, 516, 526 ; 606 ; 814) est filiforme.

20. Matrice selon la revendication 18, ***caractérisée* en ce que** ledit élément (112 ; 305, 307 ; 405, 407 ; 506, 516, 526 ; 606 ; 814) est surfacique.

21. Matrice selon l'une quelconque des revendications 18 à 20, ***caractérisée* en ce que** ledit élément (305, 306, 307 ; 405, 407 ; 506, 516, 526 ; 606) est en contact avec une reprise de contact électrique (304, 308, 309 ; 404, 408, 409 ; 508, 509 ; 518, 519 ; 528, 529 ; 608, 609).

22. Matrice selon la revendication 21, ***caractérisée* en ce que** ladite reprise de contact (304, 308, 309 ; 404, 408, 409 ; 508, 509 ; 518, 519 ; 528, 529 ; 608, 609) est réalisée sur l'une des faces latérales du composant considéré (303, 311 ; 403, 411, 412 ; 501 ; 601).

23. Matrice selon la revendication 21, ***caractérisée* en ce que** ladite reprise de contact (508, 509) est réalisée sur l'une des faces transversales (502) du composant considéré.

24. Matrice selon l'une quelconques des revendications 17 à 23, ***caractérisée* en ce que** ledit élément (112 ; 305, 307 ; 405, 407 ; 506, 516, 526 ; 606 ; 814) est constitué de plusieurs couches, dont une couche de conduction électrique et une couche de cohésion destinée à permettre l'assemblage sur la reprise de contact.

25. Matrice selon la revendication 24, ***caractérisée* en ce que** la couche externe est constituée d'un matériau choisi dans le groupe comprenant le titane (Ti), le chrome (Cr) ainsi qu'un alliage (TiW) de titane et de tungstène, et **en ce que** la couche de conduction est constituée d'un matériau choisi dans le groupe comprenant le platine, l'or, l'aluminium, le cuivre ou un alliage de cuivre et de béryllium.

26. Matrice selon l'une quelconque des revendications 18 à 25, ***caractérisée* en ce que** ledit élément (112 ; 305, 307 ; 405, 407 ; 506, 516, 526 ; 606 ; 814) est commun à tout ou partie desdits composants et forme une ligne ou une grille continue.

27. Matrice selon l'une quelconque des revendications 18 à 26, ***caractérisée* en ce que** chaque composant électronique (801) est un transistor bipolaire, dont au moins une zone semi-conductrice (805, 806 ; 1006) est formée dans l'une des faces latérales de celui-ci et est en contact avec ledit élément (814).

28. Procédé de réalisation d'un dispositif électronique comprenant une pluralité de composants électroniques (611) rapportée sur un substrat (602), ***caractérisé* en ce qu'**il consiste :
■ à réaliser une couche active (601) par épitaxie sur une strate sacrificielle (600) ;
■ à déposer et/ou implanter sur la surface libre de ladite couche active (601) des éléments fonctionnels (603) caractéristiques desdits composants (611), tels qu'une électrode, notamment une anode, et/ou une couche de métallisation permettant l'hybridation de chaque composant (611) ;
■ à graver des tranchées traversantes (620) en lignes et/ou en colonnes dans ladite couche active (601) au moins jusqu'à dégager ladite strate (600), de manière à individualiser lesdits composants (611) au sein d'une matrice ;
■ à réaliser un plot électriquement conducteur sur au moins l'une des faces libres de chaque composant (611) ainsi individualisé, de manière à réaliser des reprises de contact (608, 609) ;
■ à réaliser par dépôt au moins un film (606) électriquement conducteur s'étendant sur lesdites tranchées (620) de manière à connecter au moins deux à deux lesdites reprises de contact (608, 609) de composants (611) adjacents, ledit film (606) présentant une épaisseur déterminée pour lui conférer une élasticité susceptible de maintenir la connexion électrique malgré un déplacement relatif entre composants (611) ;
■ à hybrider les composants (611) sur le substrat (602) ;
■ à amincir sélectivement les faces de chaque composant (611) situées en regard dudit substrat (602), de manière à laisser en saillie tout ou partie desdits éléments fonctionnels (603) ;
■ à éliminer ladite strate (600) au moyen d'un usinage mécanique ou d'une attaque chimique, de manière à dégager le film électriquement conducteur (606),
lesdites étapes de réalisation de la couche active, de gravure de tranchées et de dépôt du au moins un film étant conformes au procédé selon la revendication 1.

29. Procédé de réalisation d'un dispositif électronique comprenant une pluralité de composants électroniques selon la revendication 28, ***caractérisé* en ce que** l'étape de dépôt consiste :
■ à déposer une couche en matériau électriquement isolant (741) recouvrant toute la surface de ladite couche active (701), à savoir celle de la tranchée (720) et celle desdits composants (701) ;
■ à percer ladite couche en matériau électriquement isolant (741) au moyen d'une photolithographie suivie d'une gravure opérée au fond et sur tout ou partie des bords de ladite tranchée (720) ;
■ à déposer ledit film électriquement conducteur (706) sur toute ou partie de la surface libre desdits composants (701) et desdites tranchées (720) ;
■ à ôter localement ledit film électriquement conducteur (706) par gravure des surfaces desdits composants (701).

30. Procédé de réalisation d'un dispositif électronique comprenant une pluralité de composants électroniques selon la revendication 28 ou 29, ***caractérisé* en ce que** le conducteur est constitué de plusieurs couches, dont une couche de conduction électrique et une couche de cohésion destinée à permettre l'assemblage sur la reprise de contact et **en ce que** l'étape d'élimination est effectuée sous un plasma sélectionné de manière à être inerte au moins vis-à-vis de ladite couche de conduction.

31. Dispositif électronique comprenant une pluralité de composants électroniques (303, 311 ; 403, 411, 412 ; 501 ; 601) rapportés sur un substrat (302 ; 402 ; 502), chaque composant (303, 311 ; 403, 411, 412 ; 501 ; 601) étant mécaniquement relié audit substrat (302 ; 402 ; 502 ; 602) par l'intermédiaire d'un élément de liaison (301 ; 401 ; 503 ; 603), dans lequel chaque composant (303, 311 ; 403, 411, 412 ; 501 ; 601) est en outre électriquement connecté à au moins un composant adjacent au moyen d'au moins une pièce formant un conducteur (305, 306, 307 ; 405, 407 ; 506, 516, 526 ; 606), ***caractérisé* en ce que** les composants et leurs conducteurs associés forment une matrice conforme à l'une quelconque des revendications 14 à 27.

32. Dispositif électronique selon la revendication 31, ***caractérisé* en ce que** ladite reprise de contact (508, 509) est réalisée sur la face du composant opposée à la face du composant rapportée sur ledit substrat (502).

33. Dispositif électronique selon la revendication 31, ***caractérisé* en ce que** ladite reprise de contact (304, 308, 309 ; 404, 408, 409 ; 518, 519 ; 608, 609) est réalisée sur la face du composant rapportée sur ledit substrat (302 ; 402 ; 502 ; 602).

34. Dispositif selon l'une quelconque des revendications 31 à 33, ***caractérisé* en ce que** le composant est un transistor ou une diode.

35. Détecteur de rayonnements électromagnétiques, tels que les rayons X, les rayons infrarouges ou la lumière visible, ***caractérisé* en ce qu'**il comprend un dispositif selon l'une des revendications 31 à 34, dans laquelle chaque composant (303, 311 ; 403, 411, 412 ; 501 ; 601) comprend un matériau apte à interagir avec le rayonnement considéré.

36. Emetteur de rayonnement électromagnétique, tel que des rayons laser, ***caractérisé* en ce qu'**il comprend un dispositif selon l'une des revendications 31 à 34, dans laquelle chaque composant (303, 311 ; 403, 411, 412 ; 501 ; 601) est constitué d'un émetteur laser à cavité verticale émettant par la surface (VCSEL) ou d'une diode électroluminescente.

## Claims

1. Method for producing a matrix of individual electronic components (111; 611; 801), comprising a step of producing an active layer (101; 601; 1001) on a substrate base (100; 600; 1002), particularly by epitaxy, and a step of individualizing said components by forming through trenches (102; 620; 1005), particularly by etching, in the active layer (101; 601; 1001), said individualization step leading to reveal at least the substrate base (100; 600; 1002), ***characterized* in that** it comprises steps of:
■ depositing a layer of functional material (103; 1007) on the active layer (101; 1001) and in the through trenches (102 ; 620 ; 1005);
■ depositing a resin (104; 1008) photosensitive to a preset radiation on the layer of functional material (103; 1007) in such a way as to fill said trenches (102; 1005) and to form a thin film (105) on the upper face of the electronic components (111);
■ at least partially exposing the resin (104; 1008) to said radiation while underexposing the portion of resin filling the trenches (102; 620; 1005);
■ developing the resin (104; 1008) in such a way as to remove the properly exposed portion thereof;
■ removing the functional material layer (103; 1007) portion that shows through following the development step; and
■ removing the portion of residual resin.

2. Method for producing a matrix of individual electronic components as claimed in claim 1, ***characterized* in that** the functional material (103; 1007) is resilient and/or conductive and/or opaque.

3. Method for producing a matrix of individual electronic components as claimed in one of claims 1 and 2, ***characterized* in that** the exposure step comprises a step of applying a photolithography mask (107; 1009) to the surface of the resin.

4. Method for producing a matrix of individual electronic components as claimed in claim 3, ***characterized* in that** the photolithography mask (107; 1009) comprises portions covering the trenches.

5. Method for producing a matrix of individual electronic components as claimed in any one of the previous claims, ***characterized* in that** the exposure step comprises a step of selecting a depth of field of the preset radiation, smaller than the depth of the trenches (102; 1005) and larger than the thickness of the resin film (105) covering the upper face of the electronic components (111; 801).

6. Method for producing a matrix of individual electronic components as claimed in any one of the previous claims, ***characterized* in that** the step of producing the active layer is followed by a step of depositing and/or implanting on the free surface of said active layer (101; 601; 1001) functional elements (603; 1004) characteristic of said components.

7. Method for producing a matrix of individual electronic components as claimed in claim 6, ***characterized* in that** the step of depositing and/or implanting functional elements (603; 1004) comprises a step of depositing and/or implanting an electrode and/or a metallization layer allowing each component to be hybridized.

8. Method for producing a matrix of individual electronic components as claimed in claim 6, ***characterized* in that** the active layer (1001) is a semi-conductor layer of a first type, and **in that** the step of depositing and/or implanting functional elements comprises a step of forming a semi-conductor area of a second type (1004) for each component in the free surface of the active layer.

9. Method for producing a matrix of individual electronic components as claimed in claim 8, ***characterized* in that** the step of individualizing said components by forming trenches comprises, or is followed by, a step of forming a semi-conductor area of the second type (1006) in at least one lateral face of each component.

10. Method for producing a matrix of individual electronic components as claimed in claim 8, ***characterized* in that** the step of forming semi-conductor areas of the second type in said lateral edges is implemented by doping, particularly of the "*loophole*" type.

11. Method for producing a matrix of individual electronic components as claimed in any one of claims 8 to 10 when they are dependent on claim 3, ***characterized* in that** the functional material is metal, and **in that** the photolithography mask is selected in such a way as to form a metal layer (1010) on the surface of the semi-conductor areas (1004) of the second type formed on the free surface of the active layer.

12. Method for producing a matrix of individual electronic components as claimed in claim 11, ***characterized* in that** it comprises a step of producing a conductive bump contact (813) on the surface of each of said metal layers.

13. Method for producing a matrix of individual electronic components as claimed in any one of the previous claims, ***characterized* in that** it comprises, consequent upon the development step, a step of hybridizing the matrix on a substrate (402; 502; 602; 803).

14. Matrix of at least two electronic components (111; 303, 311; 403, 411, 412; 501; 601; 801, 802) individualized in an active layer (101) on a substrate basis (100) by means of through trenches (102; 1005) formed in the active layer (101), ***characterized* in that** it comprises, for each pair of adjacent electronic components, at least one element (112; 305, 307; 405, 407; 506, 516, 526; 606; 814) connected to said components (111; 303, 311; 403, 411, 412; 501; 601; 801, 802), at least partially covering the trench (102; 1005) separating said components, and comprising at least one point of contact with each of the lateral walls defining said trench (102 ; 1005).

15. Matrix as claimed in claim 14, ***characterized* in that** each component (111; 303, 311; 403, 411, 412; 501; 601; 801, 802) has the overall shape of a regular polygon, particularly a rectangle-based parallelepiped shape.

16. Matrix as claimed in one of claims 14 and 15, ***characterized* in that** said element (112; 305, 307; 405, 407; 506, 516, 526; 606; 814) is opaque.

17. Matrix as claimed in one of claims 14 to 16, ***characterized* in that** said element (112; 305, 307; 405, 407; 506, 516, 526; 606; 814) has sufficient resilience to maintain the integrity of the electrical connection with an adjacent component despite a relative displacement between components.

18. Matrix as claimed in any one of claims 14 to 17, ***characterized* in that** said element (112; 305, 307; 405, 407; 506, 516, 526; 606; 814) is conductive.

19. Matrix as claimed in claim 18, ***characterized* in that** said element (112; 305, 307; 405, 407; 506, 516, 526; 606; 814) is filiform.

20. Matrix as claimed in claim 18, ***characterized* in that** said element (112; 305, 307; 405, 407; 506, 516, 526; 606; 814) is surface-based.

21. Matrix as claimed in any one of claims 18 to 20, ***characterized* in that** said element (305, 306, 307; 405, 407; 506, 516, 526; 606) is in contact with an electrical contact pickup (304, 308, 309; 404, 408, 409; 508, 509; 518, 519; 528, 529; 608, 609).

22. Matrix as claimed in claim 21, ***characterized* in that** said contact pickup (304, 308, 309; 404, 408, 409; 508, 509; 518, 519; 528, 529; 608, 609) is formed on one of the lateral faces of the component under consideration (303, 311; 403, 411, 412; 501; 601).

23. Matrix as claimed in claim 21, ***characterized* in that** said contact pickup (508, 509) is formed on one of the transverse faces (502) of the component under consideration.

24. Matrix as claimed in any one of claims 17 to 23, ***characterized* in that** said element (112; 305, 307; 405, 407; 506, 516, 526; 606; 814) is constituted of several layers, including an electrical conduction layer and a cohesion layer intended to allow assembly on the contact pickup.

25. Matrix as claimed in claim 24, ***characterized* in that** the external layer is constituted of a material selected from the group comprising titanium (Ti), chrome (Cr) and an alloy (TiW) of titanium and tungsten, and **in that** the conduction layer is constituted of a material selected from the group comprising platinum, gold, aluminium, copper or an alloy of copper and beryllium.

26. Matrix as claimed in one of claims 18 to 25, ***characterized* in that** said element (112; 305, 307; 405, 407; 506, 516, 526; 606; 814) is common to all or part of said components and forms a continuous line or grid.

27. Matrix as claimed in any one of claims 18 to 26, ***characterized* in that** each electronic component (801) is a bipolar transistor, whereof at least one semi-conductor area (805, 806; 1006) is formed in one of the lateral faces thereof and is in contact with said element (814).

28. Method for producing an electronic device comprising a plurality of electronic components (611) added to a substrate (602), ***characterized* in that** it comprises:
■ producing an active layer (601) by epitaxy on a sacrificial stratum (600);
■ depositing and/or implanting on the free surface of said active layer (601) functional elements (603) characteristic of said components (611), such as an electrode, particularly an anode, and/or a metallization layer allowing each component (611) to be hybridized;
■ etching through trenches (620) in rows and/or columns in said active layer (601) at least until said stratum (600) emerges, in such a way as to individualize said components (611) within a matrix;
■ producing an electrically conductive bump contact on at least one of the free faces of each component (611) so individualized, in such a way as to form contact pickups (608, 609);
■ producing by deposition at least one electrically conductive film (606) extending over said through trenches (620) in such a way as to connect at least in twos said contact pickups (608, 609) of adjacent components (611), said film (606) being of a set thickness in order to give it sufficient resilience to maintain the electrical connection despite a relative displacement between components (611) ;
■ hybridizing the components (611) on the substrate (602);
■ selectively thinning down the faces of each component (611) located facing said substrate (602), in such a way as to leave all or part of said functional elements (603) in projection;
■ removing said stratum (600) by mechanical machining or chemical attack, in such a way as to reveal the electrically conductive film (606),
said steps of producing the active layer, etching trenches and depositing the at least one film being in accordance with claim 1.

29. Method for producing an electronic device comprising a plurality of electronic components as claimed in claim 28, ***characterized* in that** the deposition step comprises:
■ depositing a layer of electrically insulating material (741) covering the whole surface of said active layer (701), namely that of the trench (720) and that of said components (701);
■ piercing said layer of electrically insulating material (741) by photolithography followed by an etching operation performed at the bottom and over all or part of the edges of said trench (720);
■ depositing said electrically conductive film (706) on all or part of the free surface of said components (701) and said trenches (720);
■ locally removing said electrically conductive film (706) by etching the surfaces of said components (701).

30. Method for producing an electronic device comprising a plurality of electronic components as claimed in claim 28 or 29, ***characterized* in that** the conductor is constituted of several layers, including an electrical conduction layer and a cohesion layer intended to allow assembly on the contact pickup and **in that** the removal step is carried out using a plasma selected in such a way as to be inert at least as regards said conduction layer.

31. Electronic device comprising a plurality of electronic components (303, 311; 403, 411, 412; 501; 601) added to a substrate (302; 402; 502), each component (303, 311; 403, 411, 412; 501; 601) being mechanically connected to said substrate (302; 402; 502; 602) by means of a link element (301; 401; 503; 603), wherein each component (303, 311; 403, 411, 412; 501; 601) is additionally electrically connected to at least one adjacent component by means of a part forming a conductor (305, 306, 307; 405, 407; 506, 516, 526; *606),* ***characterized* in that** the components and associated conductors thereof form a matrix in accordance with any one of claims 14 to 27.

32. Electronic device as claimed in claim 31, ***characterized* in that** said contact pickup (508, 509) is formed on the component face opposite the component face that is applied onto said substrate (502).

33. Electronic device as claimed in claim 31, ***characterized* in that** said contact pickup (304, 308, 309; 404, 408, 409; 518, 519; 608, 609) is formed on the component face that is applied onto said substrate (302; 402; 502; 602).

34. Electronic device as claimed in any one of claims 31 to 33, ***characterized* in that** the component is a transistor or a diode.

35. Detector of electromagnetic radiation, such as X-rays, infrared rays or visible light, ***characterized* in that** it comprises a device as claimed in one of claims 31 to 34, wherein each component (303, 311; 403, 411, 412; 501; 601) comprises a material able to interact with the radiation under consideration.

36. Emitter of electromagnetic radiation, such as laser beams, ***characterized* in that** it comprises a device as claimed in one of claims 31 to 34, wherein each component (303, 311; 403, 411, 412; 501; 601) is constituted by a vertical-cavity surface-emitting laser emitter (VCSEL) or a light-emitting diode.

## Patentansprüche

1. Verfahren zur Herstellung einer Matrix aus einzelnen elektronischen Komponenten (111; 611; 801) mit einem Schritt der Herstellung einer aktiven Schicht (101; 601; 1001) auf einer Substratbasis (100; 600; 1002), insbesondere durch Epitaxie, und einem Schritt der Vereinzelung der Komponenten durch Bildung von überspannenden Einschnitten (102; 620; 1005), insbesondere durch Ätzen in der aktiven Schicht (101; 601; 1001), wobei der Schritt der Vereinzelung mindestens zu der Freigabe der Substratbasis (100; 600; 1002) führt, ***dadurch gekennzeichnet,* dass** er die folgenden Schritte aufweist:
- Aufbringen einer Schicht aus funktionalem Material (103; 1007) auf der aktiven Schicht (101; 1001) und in den überspannenden Einschnitten (102; 620; 1005);
- Aufbringen eines Photoresist (104; 1008) mit festgelegter Strahlung auf der Schicht aus funktionalem Material (103; 1007), um die Einschnitte (102; 1005) zu füllen und auf der Oberseite der einzelnen elektronischen Komponenten (111) eine dünne Schicht (105) zu bilden;
- mindestens teilweises Belichten des Photoresist (104; 1008) mit der Strahlung, wobei der Abschnitt des Photoresist, der die Einschnitte (102; 620; 1005) füllt, gleichzeitig unterbelichtet wird;
- Entwickeln des Photoresist (104; 1008), so dass der richtig belichtete Abschnitt eliminiert wird;
- Eliminieren des Abschnittes der Schicht aus funktionalem Material (103; 1007), der nach dem Schritt des Entwickelns zutage tritt; und
- Eliminieren des restlichen Photoresist.

2. Verfahren zur Herstellung einer Matrix aus einzelnen elektronischen Komponenten nach Anspruch 1, ***dadurch gekennzeichnet,* dass** das funktionale Material (103; 1007) elastisch und/oder leitend und/oder lichtundurchlässig ist.

3. Verfahren zur Herstellung einer Matrix aus einzelnen elektronischen Komponenten nach Anspruch 1 und 2, ***dadurch gekennzeichnet,* dass** der Schritt der Belichtung einen Schritt des Aufbringens einer photolithographischen Maske (107; 1009) auf der Oberfläche des Photoresist aufweist.

4. Verfahren zur Herstellung einer Matrix aus einzelnen elektronischen Komponenten nach Anspruch 3, ***dadurch gekennzeichnet,* dass** die photolithographischen Maske (107; 1009) Abschnitte zur Abdeckung der Einschnitte aufweist.

5. Verfahren zur Herstellung einer Matrix aus einzelhen elektronischen Komponenten nach einem der vorhergehenden Ansprüche, ***dadurch gekennzeichnet,* dass** der Schritt der Belichtung einen Schritt der Auswahl einer Tiefe des festgelegten Strahlungsfeldes aufweist, die geringer ist als die Tiefe der Einschnitte (102; 1005) und größer ist als die Stärke der dünnen Photoresistschicht (105), die die Oberseite der elektronischen Komponenten (111; 801) bedeckt.

6. Verfahren zur Herstellung einer Matrix aus einzelnen elektronischen Komponenten nach einem der vorhergehenden Ansprüche, ***dadurch gekennzeichnet,* dass** der Schritt der Herstellung der aktiven Schicht gefolgt ist von einem Schritt des Aufbringens und/oder Einführens von funktionalen Elementen (603; 1004) auf der freien bzw. in die freie Oberfläche der aktiven Schicht (101; 601; 1001).

7. Verfahren zur Herstellung einer Matrix aus einzelnen elektronischen Komponenten nach Anspruch 6, ***dadurch gekennzeichnet,* dass** der Schritt der Aufbringung und/oder des Einführens von funktionalen Elementen (603; 1004) einen Schritt der Aufbringung und/oder des Einführens einer Elektrode und/oder einer Metallisierungsschicht aufweist, die die Hybridisierung jeder Komponente erlaubt.

8. Verfahren zur Herstellung einer Matrix aus einzelnen elektronischen Komponenten nach Anspruch 6, ***dadurch gekennzeichnet,* dass** es sich bei der aktiven Schicht (1001) um eine halbleitende Schicht eines ersten Typs handelt, und dass der Schritt der Aufbringung und/oder des Einführens von funktionalen Elementen einen Schritt der Bildung einer halbleitenden Zone eines zweiten Typs (1004) für jede Komponente in der freien Oberfläche der aktiven Schicht aufweist.

9. Verfahren zur Herstellung einer Matrix aus einzelnen elektronischen Komponenten nach Anspruch 8, ***dadurch gekennzeichnet,* dass** der Schritt der Vereinzelung der Komponenten durch Bildung von Einschnitten einen Schritt der Bildung einer halbleitenden Zone des zweiten Typs (1006) in mindestens einer Seitenfläche jeder Komponente aufweist oder von ihm gefolgt ist.

10. Verfahren zur Herstellung einer Matrix aus einzelnen elektronischen Komponenten nach Anspruch 8, ***dadurch gekennzeichnet,* dass** der Schritt der Bildung halbleitender Zonen des zweiten Typs in den Seitenrändern durch Dotieren, Insbesondere vom Typ *"loophole",* durchgeführt wird.

11. Verfahren zur Herstellung einer Matrix aus einzelnen elektronischen Komponenten nach einem der Ansprüche 8 bis 10, wenn sie von Anspruch 3 abhängen, ***dadurch gekennzeichnet,* dass** das funktionale Material metallisch ist, und dass die photolithographischen Maske so ausgewählt ist, dass sie auf der Oberfläche der halbleitenden Zonen (1004) des zweiten Typs, die an der freien Oberfläche der aktiven Schicht gebildet sind, eine Metallschicht (1010) bildet.

12. Verfahren zur Herstellung einer Matrix aus einzelnen elektronischen Komponenten nach Anspruch 11, ***dadurch gekennzeichnet,* dass** es einen Schritt der Herstellung eines leitenden Kontaktes (813) an der Oberfläche jeder der Metallschichten aufweist:

13. Verfahren zur Herstellung einer Matrix aus einzelnen elektronischen Komponenten nach einem der vorhergehenden Ansprüche, ***dadurch gekennzeichnet,* dass** es anschließend an den Schritt der Entwicklung einen Schritt der Hybridisierung der Matrix auf einem Substrat (402; 502; 602; 803) aufweist.

14. Matrix aus mindestens zwei elektronischen Komponenten (111; 303; 311; 403, 411, 412; 501; 601; 801; 802), die in einer aktiven Schicht (101) auf einer Substratbasis (100) mittels überspannender Einschnitte (102; 1005), welche in der aktiven Schicht (101) gebildet sind, vereinzelt sind, ***dadurch gekennzeichnet,* dass** sie für jedes Paar aneinander angrenzender elektronischer Komponenten mindestens ein Element (112; 305, 307; 405, 407; 506, 516, 526; 606; 814) aufweist, das mit den Komponenten (111; 303, 311; 403, 411, 412; 501; 601; 801, 802) verbunden ist, wobei das Element mindestens teilweise den Einschnitt (102; 1005) bedeckt, die Komponenten voneinander trennt, und mindestens einen Kontaktpunkt mit jeder der Seitenwände, die den Einschnitt (102; 1005) bildet, besitzt.

15. Matrix nach Anspruch 14, ***dadurch gekennzeichnet,* dass** jede Komponente (111; 303; 403, 411, 412; 501; 601; 801, 802) im wesentlichen die Form eines gleichmäßigen Polygons aufweist, insbesondere eine parallelepipedische Form mit rechteckiger Basis.

16. Matrix nach einem der Ansprüche 14 und 15, ***dadurch gekennzeichnet,* dass** das Element (112; 305, 307; 405, 407; 506, 516, 526; 606; 814) lichtundurchlässig ist.

17. Matrix nach den Ansprüchen 14 bis 16, ***dadurch gekennzeichnet,* dass** das Element (112; 305, 307; 405, 407; 506, 516, 526; 606; 814) eine Elastizität aufweist, die in der Lage ist, trotz einer relativen Verschiebung zwischen den Komponenten die Unversehrtheit der elektrischen Verbindung mit einer angrenzenden Komponente zu bewahren.

18. Matrix nach einem der Ansprüche 14 bis 17, ***dadurch gekennzeichnet,* dass** es sich bei dem Element (112; 305, 307; 405, 407; 506, 516, 526; 606; 814) um einen Leiter handelt.

19. Matrix nach Anspruch 18, ***dadurch gekennzeichnet,* dass** es sich bei dem Element (112; 305, 307; 405, 407; 506, 516, 526; 606; 814) um ein fadenförmiges Element handelt.

20. Matrix nach Anspruch 18, ***dadurch gekennzeichnet,* dass** es sich bei dem Element (112; 305, 307; 405, 407; 506, 516, 526; 606; 814) um ein flächenbezogenes Element handelt.

21. Matrix nach einem der Ansprüche 18 bis 20, ***dadurch gekennzeichnet,* dass** das Element (305, 306, 307; 405, 407; 506, 516, 526; 606) mit einer Fortsetzung eines elektrischen Kontaktes (304, 308, 309; 404, 408, 409; 508, 509; 518, 519; 528, 529; 608, 609) in Kontakt ist.

22. Matrix nach Anspruch 21, ***dadurch gekennzeichnet,* dass** die Fortsetzung des Kontakts (304, 308, 309; 404, 408, 409; 508, 509; 518, 519; 528, 529; 608, 609) an einer der Seitenflächen der betreffenden Komponente (303, 311; 403, 411, 412; 501; 601) hergestellt ist.

23. Matrix nach Anspruch 21, ***dadurch gekennzeichnet,* dass** die Fortsetzung des Kontaktes (508, 509) an einer der querverlaufenden Stirnflächen (502) der betreffenden Komponente hergestellt ist.

24. Matrix nach einem der Ansprüche 17 bis 23, ***dadurch gekennzeichnet,* dass** das Element (112; 305, 307; 405, 407; 506, 516, 526; 606; 814) mehrere Schichten aufweist, wobei eine Schicht mit elektrischer Leitfähigkeit eine Kohäsionsschicht ist, die die Montage an der Fortsetzung des Kontaktes ermöglichen soll.

25. Matrix nach Anspruch 24, ***dadurch gekennzeichnet,* dass** die Außenschicht ein Material aufweist, das aus der Gruppe mit Titan (Ti), Chrom (Cr) sowie einer Legierung (TiW) aus Titan und Wolfram ausgewählt ist, und dass die leitende Schicht ein Material aufweist, das aus der Gruppe mit Platin, Gold, Aluminium, Kupfer oder einer Legierung aus Kupfer und Beryllium ausgewählt ist.

26. Matrix nach einem der Ansprüche 18 bis 25, ***dadurch gekennzeichnet,* dass** das Element (112; 305, 307; 405, 407; 506, 516, 526; 606; 814) allen Komponenten oder einem Teil der Komponenten gemeinsam ist und eine Linie oder ein kontinuierliches Gitter bildet.

27. Matrix nach einem der Ansprüche 18 bis 26, ***dadurch gekennzeichnet,* dass** jede elektronische Komponente (801) ein bipolarer Transistor ist, wobei mindestens eine halbleitende Zone (805, 806; 1006) in einer der Seitenflächen gebildet ist und mit dem Element (814) in Kontakt ist.

28. Verfahren zur Herstellung eines elektronischen Bauelementes mit einer Vielzahl elektronischer Komponenten (611), die auf einem Substrat (602) aufgesetzt sind, ***dadurch gekennzeichnet,* dass** es auf folgendem beruht:
- Herstellen einer aktiven Schicht (601) durch Epitaxie auf einer Schicht *(strate sacrificelle)* (600);
- Aufbringen und/oder Einführen funktionaler Elemente (603), die für die Komponenten (611) charakteristisch sind, auf der freien Oberfläche der aktiven Schicht (601), wie beispielsweise eine Elektrode, insbesondere eine Anode, und/oder eine Metallisierungsschicht, die die Hybridisierung jeder Komponenten (611) erlaubt;
- Ätzen der überspannenden Einschnitte (620) in Linien und/oder Spalten in der aktiven Schicht (601) mindestens bis zur Freigabe der Schicht (600), um die Komponenten (611) im Innern der Matrix zu vereinzeln;
- Herstellen eines elektrisch leitenden Kontaktes auf mindestens einer der freien Seiten jeder auf diese Art und Weise vereinzelten Komponenten (611), um Fortsetzungen des Kontaktes (608, 609) herzustellen;
- Herstellen mindestens eines elektrisch leitenden Films (606) durch Aufbringen, der über den überspannenden Einschnitten (620) verläuft, um die Fortsetzungen des Kontaktes (608, 609) der angrenzenden Komponenten (611) mindestens paarweise zu verbinden, wobei der Film (606) eine festgelegte Stärke aufweist, die ihm eine Elastizität verleiht, mit der die elektrische Verbindung trotz einer relativen Verschiebung der Komponenten (611) aufrechterhalten werden kann;
- Hybridisieren der Komponenten (611) auf dem Substrat (602);
- gezieltes Verschlanken der Flächen jeder Komponente (611), die gegenüber dem Substrat (602) angeordnet sind, so dass alle oder ein Teil der funktionalen Elemente (603) weiterhin vorsteht;
- Eliminieren der Schicht (600) mit Hilfe einer mechanischen Bearbeitung oder eines chemischen Angriffs, um den elektrisch leitenden Film (606) zu lösen,
wobei die Schritte der Herstellung der aktiven Schicht, des Ätzens der Einschnitte und des Aufbringens des mindestens einen Films dem Verfahren nach Anspruch 1 entsprechen.

29. Verfahren zur Herstellung eines elektronischen Bauelementes mit einer Vielzahl elektronischer Komponenten nach Anspruch 28, ***dadurch gekennzeichnet,* dass** der Schritt des Aufbringens auf folgendem beruht:
- Aufbringen einer Schicht aus elektrisch isolierendem Material (741), das die gesamte Oberfläche der aktiven Schicht (701) bedeckt, nämlich die des Einschnittes (720) und die der Komponenten (701);
- Durchbohren der Schicht aus elektrisch isolierendem Material (741) mit Hilfe einer Photolithographie, gefolgt von einem Ätzen, das auf der Unterseite und an allen oder einem Teil der Kanten des Einschnittes (720) durchgeführt wird;
- Aufbringen des elektrisch leitenden Films (706) an der gesamten oder an einem Teil der freien Oberfläche der Komponenten (701) und der Einschnitte (720);
- lokalem Abziehen des elektrisch leitenden Films (706) durch Ätzen der Oberflächen der Komponenten (701).

30. Verfahren zur Herstellung eines elektronischen Bauelementes mit einer Vielzahl elektronischer Komponenten nach Anspruch 28 oder 29, ***dadurch gekennzeichnet,* dass** der Leiter mehrere Schichten aufweist, wobei eine Schicht mit elektrischer Leitfähigkeit eine Kohäsionsschicht ist, die die Montage an der Fortsetzung des Kontaktes ermöglichen soll, und dass der Schritt der Eliminierung unter einem ausgewählten Plasma durchgeführt wird, so dass es mindestens gegenüber der leitfähigen Schicht inert ist.

31. Elektronisches Bauelement mit einer Vielzahl elektronischer Komponenten (303, 311; 403, 411, 412; 501; 601), die auf einem Substrat (302; 402; 502) aufgesetzt sind, wobei jede Komponente (303, 311; 403, 411, 412; 501; 601) mit Hilfe eines Verbindungselementes (301; 401; 503; 603) mechanisch mit dem Substrat (302; 402; 502; 602) verbunden ist, wobei jede Komponente (303, 311; 403, 411, 412; 501; 601) außerdem mit mindestens einer angrenzenden Komponente mittels mindestens eines Teils elektrisch verbunden ist, das einen Leiter (305, 306, 307; 405, 407; 506, 516, 526; 606) bildet, ***dadurch gekennzeichnet,* dass** diese Komponenten und ihre zugehörigen Leiter eine Matrix nach einer der Ansprüche 14 bis 27 bilden.

32. Elektronisches Bauelement nach Anspruch 31, ***dadurch gekennzeichnet,* dass** die Fortsetzung des Kontaktes (508, 509) auf der Seite der Komponente hergestellt ist, die der Seite der auf dem Substrat (502) aufgesetzten Komponente gegenüberliegt.

33. Elektronisches Bauelement nach Anspruch 31, ***dadurch gekennzeichnet,* dass** die Fortsetzung des Kontaktes (304, 308, 309; 404, 408, 409; 518, 519; 608, 609) auf der Seite der Komponente, die auf dem Substrat (302; 402; 502; 602) aufgesetzt ist, hergestellt ist.

34. Bauelement nach einem der Ansprüche 31 bis 33, ***dadurch gekennzeichnet,* dass** die Komponente ein Transistor oder eine Diode ist.

35. Detektor für elektromagnetische Strahlungen, wie beispielsweise Röntgenstrahlen, Infrarotstrahlen oder sichtbares Licht, ***dadurch gekennzeichnet,* dass** er ein Bauelement nach einem der Ansprüche 31 bis 34 aufweist, bei dem jede Komponente (303, 311; 403, 411, 412; 501; 601) ein Material aufweist, das geeignet ist, mit der betreffenden Strahlung zu interagieren.

36. Elektromagnetischer Sender, wie beispielsweise Laserstrahlen, ***dadurch gekennzeichnet,* dass** er ein Bauelement nach einem der Ansprüche 31 bis 34 aufweist, bei dem jede Komponente (303, 311; 403, 411, 412; 501; 601) einen Oberflächenemitter (VCSEL) oder eine Leuchtdiode (LED) aufweist.
